(19) Europäisches Patentamt
European Patent Office
Office européen des brevets

(11) **EP 4 681 919 A1**

(12) **EUROPEAN PATENT APPLICATION**
published in accordance with Art. 153(4) EPC

(43) Date of publication:
**21.01.2026 Bulletin 2026/04**

(21) Application number: **24774955.9**

(22) Date of filing: **21.03.2024**

(51) International Patent Classification (IPC):
**B32B 27/30** (2006.01) **B32B 3/26** (2006.01)
**C09J 7/38** (2018.01) **C09J 11/06** (2006.01)
**C09J 133/00** (2006.01) **G02B 5/30** (2006.01)
**H10K 50/856** (2023.01) **H10K 59/95** (2026.01)

(52) Cooperative Patent Classification (CPC):
**B32B 3/26; B32B 27/30; C09J 7/38; C09J 11/06;
C09J 133/00; G02B 5/30;** H10K 50/856;
H10K 59/95

(86) International application number:
**PCT/JP2024/011016**

(87) International publication number:
**WO 2024/195821 (26.09.2024 Gazette 2024/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.03.2023 JP 2023046050**

(71) Applicant: **Nitto Denko Corporation**
**Osaka 567-8680 (JP)**

(72) Inventors:
• **HAMADA, Chie**
  **Ibaraki-shi, Osaka 567-8680 (JP)**
• **SUGINO, Akiko**
  **Ibaraki-shi, Osaka 567-8680 (JP)**
• **MATSUNO, Koji**
  **Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**

(54) **LAMINATE, OPTICAL MEMBER, OPTICAL DEVICE, AND METHOD FOR PRODUCING LAMINATE**

(57) Provided is a laminate including a pressure-sensitive adhesive/adhesive less liable to intrude into recessed portion of an uneven structure, and excellent in adhesive force or pressure-sensitive adhesive force to other member(s). In a laminate 100A, a first optical sheet 10a includes a first main surface 12s with an uneven structure, and a second main surface 18s opposite to the first main surface 12s, the pressure-sensitive adhesive/adhesive layer 20a is arranged on the first main surface side 12s of the first optical sheet 10a, the uneven structure of the first main surface 12s includes a plurality of recessed portions 14, and a flat portion 10s between each two adjacent recessed portions among the plurality of recessed portions 14, the flat portion 10s of the first main surface 12s is in contact with a surface of the pressure-sensitive adhesive/adhesive layer 20a, the pressure-sensitive adhesive/adhesive layer 20a includes a (meth)acrylic polymer, and a nanoindentation hardness, measured by pressing an indenter of a nanoindenter into the pressure-sensitive adhesive/adhesive layer 20a by 2000 nm, is 0.1 MPa or more and 2.0 MPa or less.

EP 4 681 919 A1

FIG. 1A

FIG. 1B

**Description**

TECHNICAL FIELD

The present disclosure relates to a laminate, an optical member, an optical apparatus, and a method for producing the laminate.

BACKGROUND ART

An optical sheet having a uneven structure on its surface sometimes includes an adhesive layer on the uneven surface. The optical sheet is, for example, attached to other member(s) such as a light guiding layer via the adhesive layer for its use (Patent Literature 1).

Patent Literature 1 describes that, the function of the optical sheet is affected by the extent to which the adhesive layer intrudes into (fills) the recessed portions of the uneven structure, when the adhesive layer is attached to the uneven surface of the optical sheet. Therefore, Patent Literature 1 proposes to provide an optical laminate having an adhesive layer that is less liable to intrude into recessed portions of an uneven structure of an optical sheet, and an optical apparatus having such an optical laminate.

Citation List

Patent Literature

Patent Literature 1: WO 2022/176659

SUMMARY OF INVENTION

Technical Problem

However, adhesives or pressure-sensitive adhesives that are made excessively hard to suppress the intrusion into the recessed portions of the uneven structure, may fail to be effectively attached to other member(s) due to the decreased adhesive force or pressure-sensitive adhesive force. On the other hand, adhesives or pressure-sensitive adhesives with excessively lowered hardness may excessively intrude into the recessed portions of the uneven structure.

Hence, it is an object of the present disclosure to provide a laminate including a pressure-sensitive adhesive/adhesive that is less liable to intrude into recessed portions of an uneven structure and at the same time excellent in adhesive force or pressure-sensitive adhesive force to other member(s), an optical member including the laminate, an optical apparatus including the laminate, a method for producing the laminate.

Solution to Problem

To achieve the above object, the present disclosure provides a laminate including a first optical sheet, and a pressure-sensitive adhesive/adhesive layer. The first optical sheet includes a first main surface with an uneven structure, and a second main surface opposite to the first main surface. The pressure-sensitive adhesive/adhesive layer is arranged on the first surface side of the first optical sheet. The uneven structure of the first main surface includes a plurality of recessed portions, and a flat portion between each two adjacent recessed portions among the plurality of recessed portions. The flat portion of the first main surface is in contact with the pressure-sensitive adhesive/adhesive layer. The pressure-sensitive adhesive/adhesive layer includes a (meth)acrylic polymer. A nanoindentation hardness, measured by pressing an indenter of a nanoindenter into the pressure-sensitive adhesive/adhesive layer by 2,000 nm, is 0.1 MPa or more and 2.0 MPa or less.

The present disclosure also provides an optical laminate including the laminate of the present disclosure.

The present disclosure also provides an optical apparatus including the optical member of the present disclosure.

The present disclosure also provides a method for producing the laminate of the present disclosure, including attaching the pressure-sensitive adhesive/adhesive layer to the first main surface of the first optical sheet.

Advantageous Effects of Invention

The present disclosure can provide a laminate including a pressure-sensitive adhesive/adhesive that is less liable to intrude into recessed portions of an uneven structure and at the same time excellent in adhesive force or pressure-sensitive adhesive force to other member(s), an optical member including the laminate, an optical apparatus including the laminate, a method for producing the laminate.

BRIEF DESCRIPTION OF DRAWINGS

[FIG. 1A] FIG. 1A is a schematic cross-sectional view showing an example configuration of the optical laminate of the present disclosure.
[FIG. 1B] FIG. 1B is a schematic cross-sectional view showing another example configuration of the optical laminate of the present disclosure.
[FIG. 2] FIG. 2 is a schematic cross-sectional view showing an enlarged portion of the optical laminate of FIG. 1A.
[FIG. 3] FIG. 3 is a schematic perspective view of a first optical sheet in the optical laminate of FIG. 1A.
[FIG. 4A] FIG. 4A is a schematic cross-sectional view showing an example of an illumination apparatus including the optical laminate of FIG. 1A.
[FIG. 4B] FIG. 4B is a schematic cross-sectional view showing another example of the illumination apparatus including the optical laminate of FIG. 1A.
[FIG. 5A] FIG. 5A is a schematic plan view showing another example of the first optical sheet in the optical laminate of the present disclosure.
[FIG. 5B] FIG. 5B is a schematic cross-sectional view of the first optical sheet of FIG. 5A.
[FIG. 6A] FIG. 6A is a schematic plan view showing a still another example of the first optical sheet in the optical laminate of the present disclosure.
[FIG. 6B] FIG. 6B is a schematic cross-sectional view of a recessed portion in a first main surface of the first optical sheet of FIG. 6A.
[FIG. 6C] FIG. 6C is a schematic plan view of the recessed portion in the first main surface of the first optical sheet of FIG. 6A.

DESCRIPTION OF EMBODIMENTS

Next, the present disclosure will be described more specifically with reference to examples. However, the present disclosure is by no means limited by the following description.

As used herein, a "pressure-sensitive adhesive/adhesive layer" refers to a layer formed of at least either of a pressure-sensitive adhesive or an adhesive. As used herein, the " pressure-sensitive adhesive/adhesive layer" may be a "pressure-sensitive adhesive layer" formed of a pressure-sensitive adhesive, an "adhesive layer" formed of an adhesive, or a layer including both a pressure-sensitive adhesive and an adhesive, unless otherwise specified. Further, as used herein, a pressure-sensitive adhesive and an adhesive is sometimes collectively referred to as a "pressure-sensitive adhesive/adhesive". In general, an agent having relatively weak pressure-sensitive adhesive force or adhesive force (e.g., an agent that bonds adherends in a peelable manner) is sometimes called a "pressure-sensitive adhesive", and an agent having relatively strong pressure-sensitive adhesive force or adhesive force (e.g., an agent that bonds adherends in a non-peelable or hardly peelable manner) is sometimes called an "adhesive", for distinction. As used herein, there is no clear distinction between a "pressure-sensitive adhesive" and an "adhesive". Also, as used herein, there is no clear distinction between "pressure-sensitive adhesive force" and "adhesive force".

As used herein, "on" or "on a surface" may indicate directly contacting or being in contact with the surface with another layer or the like interposed therebetween.

The laminate of the present disclosure may include, for example, a nitrogen-containing monomer as a monomer unit in the (meth)acrylic polymer. The nitrogen-containing monomer may be, for example, a heterocycle-containing acrylic monomer.

In the laminate of the present disclosure, for example, the (meth)acrylic polymer may be a (meth)acrylic polymer having a weight-average molecular weight of 500,000 to 3,500,000 obtained by polymerizing 3 to 20 wt% of a heterocycle-containing acrylic monomer (heterocycle-containing acrylate), 0.5 to 5 wt% of (meth)acrylic acid, 0.05 to 2 wt% of a hydroxyalkyl (meth)acrylate, and 83 to 96.45 wt% of alkyl (meth)acrylate, as monomer components.

In the pressure-sensitive adhesive/adhesive layer of the laminate of the present disclosure, for example, the nitrogen-containing monomer may be a monomer having one or two reactive double bonds per molecule. The monomer having one or two reactive double bonds per molecule may be, for example, a heterocycle-containing acrylic monomer (heterocycle-containing acrylate).

In the laminate of the present disclosure, the gel fraction of the pressure-sensitive adhesive/adhesive forming the pressure-sensitive adhesive/adhesive layer may be, for example, 85 wt% or more, more than 85 wt%, 90 wt% or more, 91 wt% or more, or 93 wt% or more, and for example, 100 wt% or less, 99 wt% or less, or 98 wt% or less.

In the laminate of the present disclosure, the pressure-sensitive adhesive/adhesive layer may be, for example, a layer formed by a method including preparing a pressure-sensitive adhesive/adhesive coating solution including a (meth) acrylic polymer, applying the pressure-sensitive adhesive/adhesive coating solution to a substrate, and heating and drying the substrate to which the pressure-sensitive adhesive/adhesive coating solution has been applied. In the laminate of the present disclosure, for example, the pressure-sensitive adhesive/adhesive layer may be formed from the pressure-sensitive adhesive/adhesive coating solution having a specific composition as described above, and may be integrated with a void-containing layer. Thus, for example, it is possible to suppress serious permeation of the pressure-sensitive adhesive/adhesive layer into the void-containing layer even under a particularly long-term heat durability test, for example. The pressure-sensitive adhesive/adhesive coating solution may further include, for example, a crosslinking agent, or may contain other component(s) as described later.

In the pressure-sensitive adhesive/adhesive coating solution for forming the pressure-sensitive adhesive/adhesive layer in the laminate of the present disclosure, the nitrogen-containing monomer preferably has a small number of functional groups (the number of reactive double bonds per molecule) in order to efficiently crosslink the main chains in graft reaction. For example, the number of reactive double bonds preferably be one or two per molecule, as described above.

In the production of the (meth)acrylic polymer, even if a monomer having one or two reactive double bonds is mixed, it is difficult to reduce the amount of the semi-polymeric polymer (which has a small molecular weight and is liable to permeate into voids of a void-containing layer) as described above. However, the present disclosure uses a pressure-sensitive adhesive/adhesive coating solution in which a monomer including one or two reactive double bonds is mixed with a (meth)acrylic polymer afterward, which are subjected to a crosslinking reaction to cause the graft reaction as described above, and thus can reduce the amount of the semi-polymeric polymer.

As used herein, "(meth)acrylic" refers to at least one of acrylic or methacrylic. For example, "(meth)acrylic acid" refers to at least one of acrylic acid or methacrylic acid. "(Meth)acrylic acid ester" refers to at least one of acrylic acid ester or methacrylic acid ester. "Methyl (meth)acrylate" refers to at least one of methyl acrylate or methyl methacrylate.

As used herein, a "(meth)acrylic polymer" refers to, for example, a polymer having a structure obtained by polymerizing components including at least one selected from the group consisting of acrylic acid, methacrylic acid, acrylic acid ester, methacrylic acid ester, a monomer having an acryloyl group, and a monomer having a methacryloyl group. The aforementioned components may appropriately or may not necessarily include a substance other than at least one selected from the group consisting of acrylic acid, methacrylic acid, acrylic acid ester, methacrylic acid ester, a monomer having an acryloyl group, and a monomer having a methacryloyl group.

As used herein, an "acrylic monomer" refers to a monomer including at least one selected from the group consisting of acrylic acid, acrylic acid ester, and a monomer having an acryloyl group.

As used herein, an "isocyanate-based crosslinking agent" refers to, for example, a crosslinking agent including an isocyanate group (isocyanato group) in the molecule. In the present disclosure, the number of the isocyanate group (isocyanato group) per molecule in the isocyanate-based crosslinking agent is not particularly limited, and is preferably 2 or more, and may be, for example, 2, 3, or 4. The upper limit thereof is not particularly limited and is, for example, 10 or less.

As used herein, an "epoxy-based crosslinking agent" refers to, for example, a crosslinking agent including an epoxy group in the molecule. In the present disclosure, the number of the epoxy group per molecule in the epoxy-based crosslinking agent is not particularly limited, and is preferably 2 or more, and may be, for example, 2, 3, or 4. The upper limit thereof is not particularly limited and is, for example, 10 or less.

[1. Laminate, optical member, and optical apparatus]

As described above, the laminate of the present disclosure includes a first optical sheet and a pressure-sensitive adhesive/adhesive layer. The first optical sheet includes a first main surface having an uneven structure, and a second main surface opposite to the first main surface. The pressure-sensitive adhesive/adhesive layer is arranged on the first main surface side of the first optical sheet. The uneven structure of the first main surface includes a plurality of recessed portions and a flat portion between two adjacent recessed portions among the plurality of recessed portions. The flat portions of the first main surface are in contact with the surface of the pressure-sensitive adhesive/adhesive layer. The pressure-sensitive adhesive/adhesive layer includes a (meth)acrylic polymer, and has a nanoindentation hardness, which is measured by pressing an indenter of a nanoindenter by 2000 nm into pressure-sensitive adhesive/adhesive layer, of 0.1 MPa or more and 2.0 MPa or less.

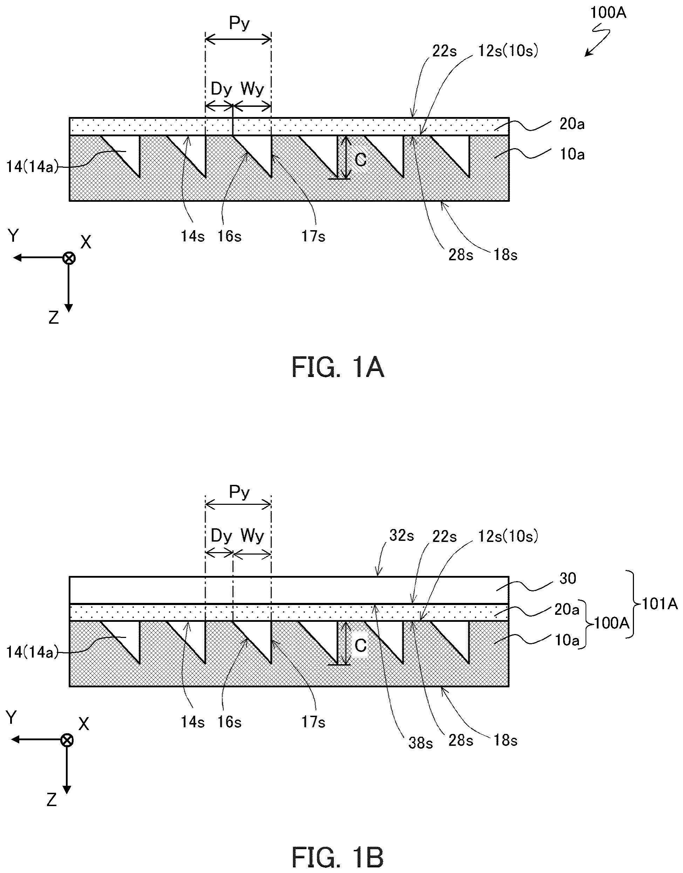

With reference to FIG. 1A, FIG. 1B, FIG. 2, FIG. 3, FIG. 4A, and FIG. 4B, the configuration of the laminate of the present disclosure will be described by way of example. Although FIG. 1A, FIG. 1B, FIG. 2, FIG. 3, FIG. 4A, and FIG. 4B are cross-sectional views, hatching is appropriately simplified or omitted for convenience in viewing.

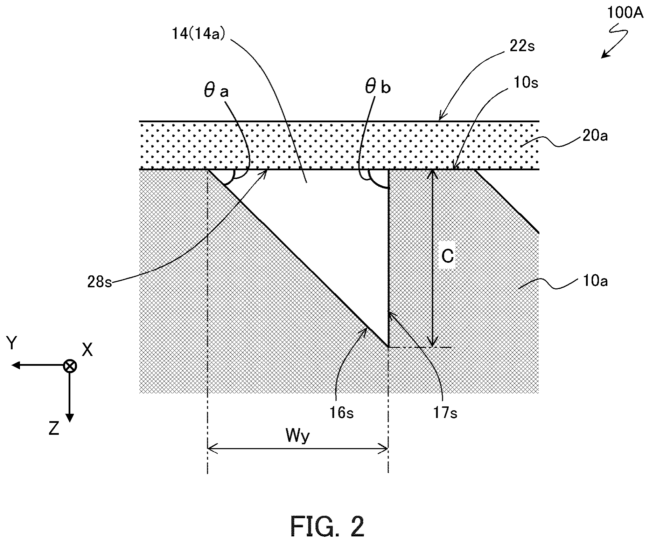

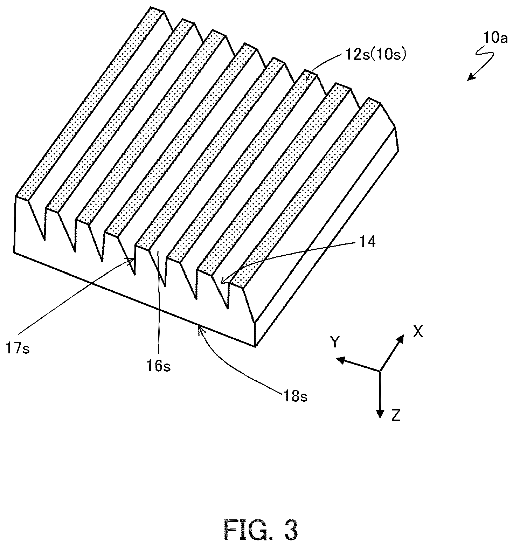

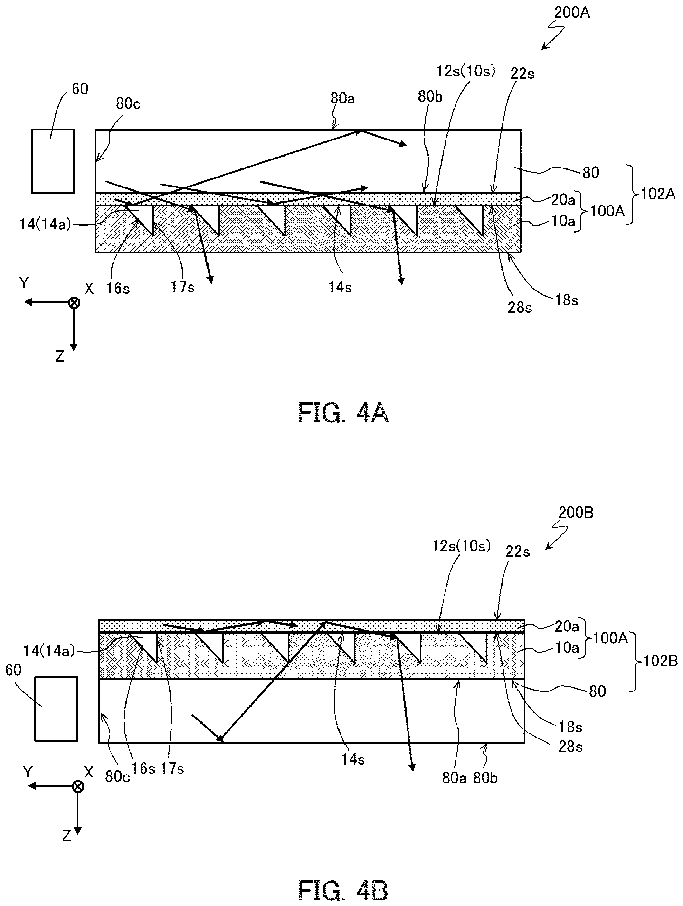

FIG. 1A shows a schematic cross-sectional view of an optical laminate 100A according to an embodiment of the present disclosure. FIG. 1B shows a schematic cross-sectional view of an optical laminate 101A according to another embodiment of the present disclosure. FIG. 2 is a schematic cross-sectional view showing an enlarged portion of the optical laminate 100A. FIG. 3 is a schematic perspective view of an optical sheet 10a in the optical laminate 100A. FIG. 4A is a schematic cross-sectional view of an illumination apparatus 200A including the optical laminate 100A.

As shown in FIG. 1A, the optical laminate 100A includes the first optical sheet 10a and a pressure-sensitive adhesive/adhesive layer 20a. The pressure-sensitive adhesive/adhesive layer 20a may be, for example, a pressure-sensitive adhesive layer formed of a pressure-sensitive adhesive, or an adhesive layer formed of an adhesive. The first optical sheet 10a includes a first main surface 12s having an uneven structure, and a second main surface 18s opposite to the first main surface 12s. The pressure-sensitive adhesive/adhesive layer 20a is arranged on the first main surface 12s side of the first optical sheet 10a. The uneven structure of the first main surface 12s includes a plurality of recessed portions 14 and a flat portion 10s between each two adjacent recessed portions 14 among the plurality of recessed portions 14. The flat portions 10s of the first main surface 12s are in contact with the pressure-sensitive adhesive/adhesive layer 20a. The pressure-sensitive adhesive/adhesive layer 20a includes a (meth)acrylic polymer. A nanoindentation hardness measured by pressing an indenter of a nanoindenter by 2000 nm into the pressure-sensitive adhesive/adhesive layer 20a is 0.1 MPa or more and 2.0 MPa or less. As shown in FIG.1A, the recessed portion 14 of the first main surface forms an internal space (space) 14a between the recessed portion 14 and the surface of the pressure-sensitive adhesive/adhesive layer 20a.

The optical laminate 101A shown in FIG. 1B is an example where the optical laminate of the present disclosure further includes an constituent element other than the first optical sheet and the pressure-sensitive adhesive/adhesive layer. As shown in FIG. 1B, the optical laminate 101A includes the optical laminate 100A and a second optical sheet 30 arranged on a side of the pressure-sensitive adhesive/adhesive layer 20a opposite to the side facing the first optical sheet 10a. The optical laminate 100A in FIG. 1B is the same as the optical laminate 100A in FIG. 1A. The description of the optical laminate 100A is also applicable to the optical laminate 101A unless otherwise specified, and thus the description thereof may be omitted to avoid duplication.

The second optical sheet 30 in the optical laminate 101A has a main surface 38s facing the pressure-sensitive adhesive/adhesive layer 20a, and a main surface 32s opposite to the main surface 38s. The main surface 38s is flat. Although not shown in FIG. 1B, at least one other optical member (e.g., an optical sheet) may be arranged on the side of the second optical sheet 30 in the optical laminate 101A opposite to the side facing the pressure-sensitive adhesive/adhesive layer 20a (i.e., on the main surface 32s). The other optical member(s) (or optical sheet) is not particularly limited, and examples thereof include a diffusion plate and a light guiding plate. The other optical member may be adhered onto the main surface 32s of the optical sheet 30 via, for example, a pressure-sensitive adhesive/adhesive layer.

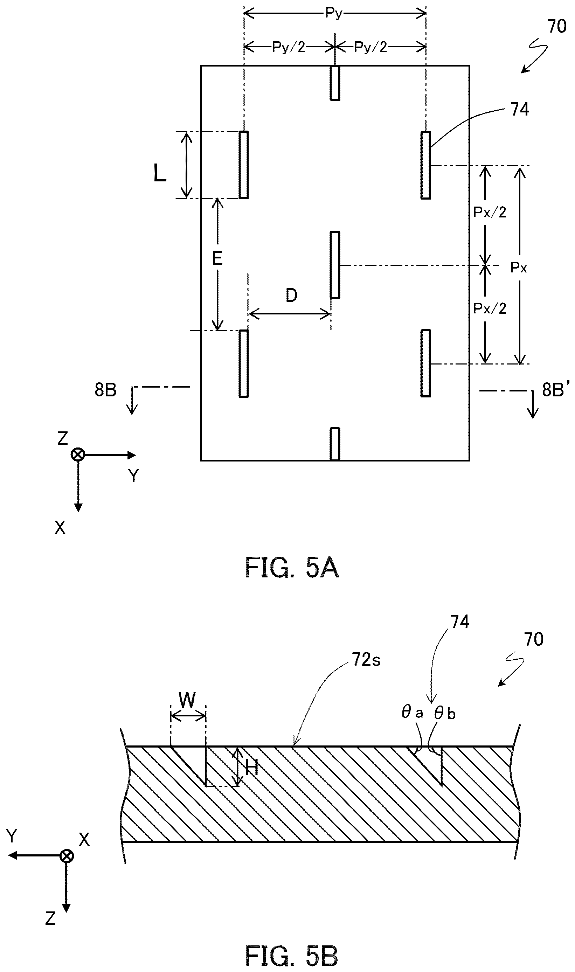

As described above, FIG. 2 is a schematic cross-sectional view showing an enlarged portion of the optical laminate 100A. In the examples shown in FIG. 1A and FIG. 2, the pressure-sensitive adhesive/adhesive layer 20a does not intrude into the recessed portions 14. In other words, the pressure-sensitive adhesive/adhesive layer 20a does not exist in the spaces defined by the recessed portions 14. The space defined by the recessed portion 14 refers to a space defined by the recessed portion 14 and a sheet surface (a surface parallel to the XY plane) including the flat portion 10s adjacent to the recessed portion 14. Therefore, the internal space 14a defined by a surface 28s of the pressure-sensitive adhesive/adhesive layer 20a facing the first optical sheet 10a and the first main surface 12s of the first optical sheet 10a coincides with the space defined by the recessed portion 14 in this example. Hereinafter, the internal space 14a may be referred to as an air cavity or an optical cavity. The internal space 14a is typically a void portion filled with air. However, the internal space 14a may be filled with a material having a refractive index lower than that of the first optical sheet 10a and the pressure-sensitive adhesive/adhesive layer 20a, instead of air. As described above, FIG. 3 is a schematic perspective view of the optical sheet 10a in the optical laminate 100A. In a plan view (XY plane) of the optical sheet viewed from the normal direction of the main surface, a plurality of the internal spaces that extend in the X direction (e.g., triangular prism-shaped grooves extending in the X direction) may be discretely provided in the Y direction as in the example of FIG. 3, or may be discretely provided in an island state in both the X direction and the Y direction as in the example of FIG. 5A to be described later. As shown in FIG. 4A and FIG. 4B to be described later, in an illumination apparatus including the optical laminate 100A, the light guide direction of the light guiding layer 80 is the -Y direction. Light propagates in various directions through the light guiding layer 80. Hereinafter, the -Y direction is referred to as a light guide direction, and light having a component in the -Y direction (i.e., a component in the -Y direction is not zero) is defined as light propagating in the -Y direction.

The optical laminate 100A functions as a light distribution structure as described in, for example, WO 2011/124765 or WO 2019/087118. In other words, the optical laminate 100A has a plurality of internal spaces 14a forming an interface that directs light in the Z direction (downward in FIG. 3) by total internal reflection. The internal space 14a is defined by a surface 16s and a surface 17s, which are included in the first main surface 12s of the first optical sheet 10a, and the surface 28s of the pressure-sensitive adhesive/adhesive layer 20a facing the first optical sheet 10a. Here, the cross-sectional shape of the internal space 14a (the shape of a cross section perpendicular to the X direction and parallel to the YZ plane) is a triangle. The interface formed by the surface 16s, which is inclined, functions as an interface that directs light in the Z direction (downward in FIG. 3) by total internal reflection. Each of the plurality of recessed portions 14, that is, each of the plurality of internal spaces 14a includes the inclined surface (first inclined surface) 16s, which directs a part of light propagating through the optical laminate 100A to the second main surface 18s side of the first optical sheet 10a (in the Z direction in FIG. 3) by total internal reflection, and the inclined surface (second inclined surface) 17s opposite to the inclined surface 16s. The inclination angle θa of the inclined surface 16s is, for example, 10° or more and 70° or less. The lower limit thereof is preferably 30° or more, and more preferably 45° or more. The inclination angle θa smaller than 10° may lead to decrease in the controllability of light distribution, and may even lead to decrease in the light extraction efficiency. On the other hand, the inclination angle θa more than 70° may lead to, for example, difficulty in processing of shaped films. Also, the inclination angle θb of the inclined surface 17s is, for example, 50° or more and 100° or less. The lower limit thereof is preferably 70° or more. The inclination angle θb smaller than 50° may lead to occurrence of stray light in an unintended direction. On the other hand, the inclination angle θb more than 100° may lead to, for example, difficulty in processing of shaped films. The inclination angle θa of the inclined surface 16s and the inclination angle θb of the inclined surface 17s are angles with respect to a direction parallel to the Y direction in a cross section of the recessed portion 14 (a cross section perpendicular to the X direction and parallel to the YZ plane). In this example, the inclination angle θa of the inclined surface 16s is smaller than the inclination angle θb of the inclined surface 17s. In the illumination apparatus including the optical laminate 100A (see FIG. 4A and FIG. 4B), the inclined surface 16s is arranged closer to a light source 60 than the inclined surface 17s. The shape of the cross section of the internal space 14a (cross section perpendicular to the X direction and parallel to the YZ plane) is defined by the inclination angle θa of the inclined surface 16s, the inclination angle θb of the inclined surface 17s, a width Wy, and a depth C. The shape of the internal space 14a (recessed portion 14) is not limited to the illustrated example, and can be variously modified. The shape, the size, the arrangement density, etc. of the internal space 14a (recessed portion 14) can be adjusted to control the distribution of light rays (light distribution) emitted from the optical laminate 100A (e.g., see Patent Literatures 2 and 3).

The optical laminate functioning as a light distribution control structure can be configured to have function of, for example, one or both of a light guiding layer and a direction conversion layer, which have the plurality of internal spaces. For example, as shown in FIG. 4A, the optical laminate 100A can be used in the illumination apparatus 200A. As shown in FIG. 4A, the illumination apparatus 200A of FIG. 4A includes the optical laminate 102A and the light source 60. As shown in FIG. 4A, the optical laminate 102A includes the optical laminate 100A, and the light guiding layer 80 arranged on the side of the pressure-sensitive adhesive/adhesive layer 20a opposite to the side facing the first optical sheet 10a. The light guiding layer 80 is, for example, adhered to a surface 22s of the pressure-sensitive adhesive/adhesive layer 20a opposite to the side facing the first optical sheet 10a. The light guiding layer 80 includes a first main surface 80a, a second main surface 80b opposite to the first main surface 80a, and a light receiving portion 80c that receives light emitted from the light source 60. The light source 60 is not particularly limited and is, for example, an LED device. A plurality of the LED devices may be arranged to be used. A part of the light guided into the light guiding layer 80 is totally internally reflected (Total Internal Reflection: TIR) at an interface 16s and an interface 14s formed by the internal spaces 14a, as indicated by arrows in FIG. 4A. The light internally totally reflected at the interface 14s (the surface 28s of the pressure-sensitive adhesive/adhesive layer 20a facing the first optical sheet) propagates through the light guiding layer 80 and the pressure-sensitive adhesive/adhesive layer 20a. The light internally totally reflected at the inclined surface 16s is emitted from the second main surface 18s side of the first optical sheet 10a, to the outside of the optical laminate 102A.

The refractive indices of the light guiding layer 80, the pressure-sensitive adhesive/adhesive layer 20a, and the first optical sheet 10a are not particularly limited, and are preferably substantially equal to each other. The difference (absolute value) between the refractive indices of the light guiding layer 80 and the pressure-sensitive adhesive/adhesive layer 20a, and the difference (absolute value) between the refractive indices of the pressure-sensitive adhesive/adhesive layer 20a and the first optical sheet 10a are respectively, for example, preferably 0.20 or less, more preferably 0.15 or less, and still more preferably 0.10 or less. The lower limit value of the absolute value is not particularly limited, and is, for example, 0 or a numerical value exceeding 0.

The thickness of the pressure-sensitive adhesive/adhesive layer 20a is not particularly limited and may be, for example, 0.01 μm or more, and 50.0 μm or less. The lower limit value of the thickness of the pressure-sensitive adhesive/adhesive layer 20a is preferably 1.0 μm or more. The upper limit value of the thickness of the pressure-sensitive adhesive/adhesive layer 20a is preferably 30.0 μm or less, and more preferably 20.0 μm or less. Unless otherwise specified, the thickness of the pressure-sensitive adhesive/adhesive layer refers to the thickness of a portion on the flat portions 10s of the first main surface 12s of the first optical sheet 10a.

The haze value of the optical laminate 100A is not particularly limited and is, for example, 5.0% or less. The lower limit value of the haze value is not particularly limited and is, for example, 0% or a numerical value exceeding 0%. The haze value can be measured, for example, using a haze meter (instrument name "HZ-1", manufactured by Suga Test Instruments Co., Ltd.) with D65 light.

FIG. 4B shows an example where the light guiding layer 80 in the illumination apparatus 200A of FIG. 4A is arranged at a position different from that in the illumination apparatus 200A of FIG. 4A. As in the illumination apparatus 200B shown in FIG. 4B, the light guiding layer 80 may be arranged on the first optical sheet 10a side of the optical laminate 100A (closer to the first optical sheet 10a than the pressure-sensitive adhesive/adhesive layer 20a). The light guiding layer 80 and the first optical sheet 10a may be attached to each other via, for example, a pressure-sensitive adhesive/adhesive layer (not shown). Also in the illumination apparatus 200B, the light internally totally reflected at the interface 14s (the surface 28s of the pressure-sensitive adhesive/adhesive layer 20a facing the first optical sheet) propagates through the pressure-sensitive adhesive/adhesive layer 20a. The light internally totally reflected at the inclined surface 16s is emitted from the second main surface 18s side of the first optical sheet 10a, to the outside of the optical laminate 102B.

As described above, FIG. 4A and FIG. 4B each show an example of the illumination apparatus of the present disclosure. The illumination apparatus of the present disclosure is an example aspect of the optical apparatus of the present disclosure. However, the optical apparatus of the present disclosure is not limited only to the illumination apparatus. The optical apparatus of the present disclosure and the illumination apparatus of the present disclosure are not limited to the examples of FIG. 4A and FIG. 4B, and various modifications can be applied thereto. For example in the illumination apparatus 200A, a substrate layer may be provided on a side of the optical laminate 100A opposite to the side facing the light guiding layer 80. Further, an antireflection layer may be provided instead of the substrate layer, and a hard coat layer (e.g., having a pencil hardness of H or more) may be provided instead of the substrate layer. Also, for example, one or both of the antireflection layer and the hard coat layer may be provided on the substrate layer. Also, for example, one or both of the antireflection layer and the hard coat layer may be provided on the side opposite to the emission surface (upper side in FIG. 4A) of the light guiding layer 80. The antireflection layer and the hard coat layer can be formed, for example, by a known method using a known material. Further, for example, a low refractive index layer may be provided between the optical laminate 102A and the substrate layer (or one or both of the antireflection layer and the hard coat layer).

In the example of the illumination apparatus 200B, the substrate layer may be provided on the side of the optical laminate 100A opposite to the side facing the light guiding layer 80. Instead of the substrate layer, one or both of the anti-reflection layer and the hard coat layer (e.g., having a pencil hardness of H or higher) may be provided. Alternatively, one or both of the anti-reflection layer and the hard coat layer may be provided on the substrate layer. Also, one or both of the anti-reflection layer and the hard coat layer may be provided on the emission surface side (lower side in FIG. 4B) of the light guiding layer 80. The low refractive index layer may be provided between the optical laminate 102B and the substrate layer (or one or both of the anti-reflection layer and the hard coat layer).

As shown in FIG. 3, in the first optical sheet 10a of FIG. 1A, FIG. 1B, FIG. 2, FIG. 4A, and FIG. 4B in plan view from the normal direction of the first main surface 12s, each of the plurality of recessed portions 14 extends and continues in the X direction. The plurality of recessed portions 14 are discretely arranged in the Y direction, and a flat portion 10s is provided between each two recessed portions 14. The recessed portions 14 are preferably arranged periodically in the Y direction, and the pitch Py thereof is, for example, 6 $\mu$m or more and 120 $\mu$m or less. The width Wy of the recessed portion 14 is, for example, 3 $\mu$m or more and 20 $\mu$m or less. The width Dy of the flat portion 10s is, for example, 3 $\mu$m or more and 100 $\mu$m or less. The ratio Wy/Dy between the width Wy of the recessed portion 14 and the width Dy of the flat portion 10s is, for example, 0.3 or more and 7 or less. The depth C (depth in the Z direction) of the recess 14 is, for example, 1 $\mu$m or more and 100 $\mu$m or less. The depth C of the recessed portion 14 is preferably 20 $\mu$m or less, and more preferably 12 $\mu$m or less. The depth C of the recessed portion 14 is preferably 4 $\mu$m or more, more preferably 6 $\mu$m or more, and still more preferably 8 $\mu$m or more.

With regard to the density of the plurality of recessed portions 14, in the first optical sheet 10a viewed in plan view from the normal direction of the first main surface 12s, the ratio of the area (area occupancy ratio) of the plurality of recessed portions 14 to the area of the first optical sheet 10a is preferably 0.3% or more, from the viewpoint of achieving good brightness. The area occupancy ratio of the plurality of recessed portions 14 is appropriately selected depending on the intended application. For example, in applications where high transparency is desirable, the area occupancy ratio is preferably 0.3% or more and 10% or less, and more preferably 0.5% or more and 4% or less. In applications where higher brightness is desirable, the area occupancy ratio is preferably 30% or more and 80% or less. Note that, the area occupancy ratio of the plurality of recessed portions 14 may be uniform, or the area occupancy ratio may increase with increasing distance from the light source (e.g., the light source 60 in FIG. 4A or FIG. 4B) so that the brightness does not decrease with increasing distance.

In the laminate of the present disclosure, the first optical sheet is not limited to the first optical sheet 10a shown in FIG. 1A to FIG. 4B. For example, instead of the first optical sheet 10a, an uneven-shaped film 70 (optical sheet) shown in FIG. 5A and FIG. 5B may be used as the first optical sheet. The uneven-shaped film 70 includes a main surface having an uneven structure, and the uneven structure includes a plurality of recessed portions 74 and flat parts 72s between the adjacent recessed portions 74. In the shaped film 70 viewed in plan from the normal direction of the main surface (e.g., see FIG. 5A), the plurality of recessed portions 74 are discretely arranged in an island state in both the X direction and the Y direction. In the shaped film 70, the size (length L, width W: see FIG. 5A and FIG. 5B) of the recessed portion 74 is, for example, preferably 10 $\mu$m or more and 500 $\mu$m or less for the length L, and preferably 1 $\mu$m or more and 100 $\mu$m or less for the width W. From the viewpoint of the light extraction efficiency, the depth H is preferably 1 $\mu$m or more and 100 $\mu$m or less. The depth H of the recessed portion 14 is preferably 20 $\mu$m or less, and more preferably 12 $\mu$m or less. The depth H of the recessed portion 14 is preferably 4 $\mu$m or more, more preferably 6 $\mu$m or more, and still more preferably 8 $\mu$m or more. In the case where the plurality of recessed portion 74 are discretely and uniformly distributed, for example, the plurality of recessed portion 74 are preferably arranged periodically, as shown in FIG. 5A. The pitch Px is, for example, preferably 10 $\mu$m or more and 500 $\mu$m or less, and the pitch Py is, for example, preferably 10 $\mu$m or more and 500 $\mu$m or less. With no limitation to the example of FIG. 5A, the plurality of recessed portions may be discretely arranged in the light guide direction of the light guiding layer and the direction intersecting the light guide direction of the light guiding layer, when used in an illumination apparatus.

With regard to the density of the plurality of recessed portions 74, in the shaped film 70 viewed in plan view from the normal direction of the main surface (FIG. 5A), the ratio of the area (area occupancy ratio) of the plurality of recessed portions 74 to the area of the shaped film 70 is preferably 0.3% or more, from the viewpoint of achieving good brightness. The area occupancy ratio of the plurality of recessed portions 74 is appropriately selected depending on the intended application. For example, in applications where high transparency is desirable, the area occupancy ratio is preferably 30% or less from the viewpoint of achieving a good visible light transmittance and haze value, and preferably 1% or more from the viewpoint of achieving good brightness. The upper limit value thereof is more preferably 25% or less, and in order to achieve a high visible light transmittance, preferably 10% or less, and more preferably 5% or less. For example, the area occupancy ratio of the plurality of recessed portions 74 is preferably 0.3% or more and 10% or less, and more preferably 0.5% or more and 4% or less. In applications where higher brightness is desirable, the area occupancy ratio is preferably 30% or more and 80% or less. Note that, the area occupancy ratio of the plurality of recessed portions 74 may be uniform, or may increase with increasing distance from the light source (e.g., the light source 60 in FIG. 4A or FIG. 4B) so that the brightness does not decrease with increasing distance.

FIGs. 1A to 4B show an example where the first optical sheet 10a includes the recessed portions 14 with triangular cross-sectional shape. However, the cross-sectional shape of the recessed portion 14 is not limited to this. For example, the cross-sectional shape of the recessed portion 14 may be any shape having a surface that can form an interface that directs light in the Z direction by total internal reflection. The cross-sectional shape of the recessed portion 14 may be, for example, quadrangular (e.g., trapezoidal), and is not limited to a polygon, and may be a shape including curves.

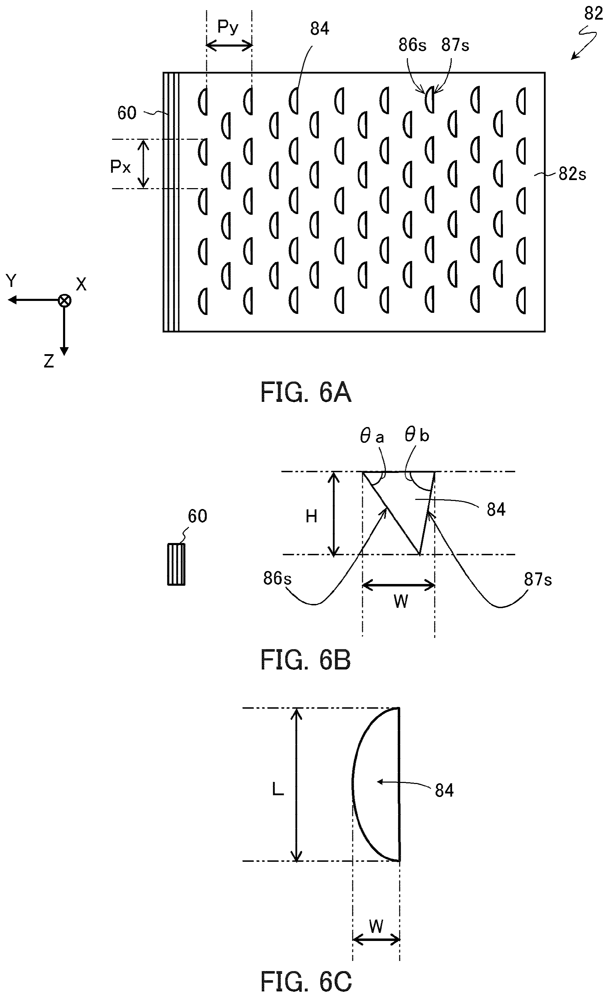

The laminate of the present disclosure may include an uneven-shaped film 82 (optical sheet) shown in FIG. 6A as the first optical sheet, instead of the first optical sheet 10a of FIGs. 1A to 4B. FIG. 6A also shows the light source 60. The uneven-shaped film 82 includes a main surface having an uneven structure, and the uneven structure includes a plurality of recessed portions 84 and flat portions 82s between the adjacent recessed portions 84. Each of the plurality of recessed portions 84 includes a first inclined surface 86s that directs a part of light propagating through the optical laminate in the Z direction by total internal reflection, and a second inclined surface 87s opposite to the first inclined surface 86s. As shown in FIG. 6A, in the uneven-shaped film 82 viewed in plan view from the normal direction of the main surface having an uneven structure, the first inclined surface 86s of the recessed portion 84 forms a curved surface that is convex toward the light source 60. When a plurality of LED devices arranged in the X direction are used as the light source 60, light emitted from each of the LED devices spreads toward the Y direction. Thus, the first inclined surface 86s with a curved surface convex toward the light source 60 allows the first inclined surface 86s to act more uniformly on the light. In a case where a coupling optical system is provided between the light source 60 and the light receiving portion 80c of the light guiding layer 80 to make light with a high degree of parallelism (light with small spread in the Y direction) incident, the first inclined surface 86s may be parallel to the X direction. Preferrable ranges of the size (lengths L, widths W: see FIGs. 6B and 6C), and depths H (see FIG. 6B), and pitches Px and Py of the recessed portion 84 may be, for example, the same as that of the recessed portion 74 of the uneven-shaped film 70.

A method for producing the optical laminate 100A is not particularly limited, and for example, the optical laminate 100A can be produced by attaching the pressure-sensitive adhesive/adhesive layer 20a to the surface 12s having the uneven structure of the first optical sheet 10a using, for example, Roll to Roll method. From the viewpoint of mass productivity, the optical laminate 100A is preferably produced by Roll-to-Roll method.

In the pressure-sensitive adhesive/adhesive layer of the laminate of the present disclosure, the nanoindentation hardness measured by pressing an indenter of a nanoindenter by 2000 nm into the pressure-sensitive adhesive/adhesive layer (hereinafter also referred to as the "nanoindentation hardness") is 0.1 MPa or more and 2.0 MPa or less, as described above. The nanoindentation hardness of the pressure-sensitive adhesive/adhesive layer is desired to be neither too low nor too high, from the viewpoint of achieving both the suppression of intrusion into the recessed portions of the uneven structure, and the adhesive force or pressure-sensitive adhesive force to other member(s). The upper limit of the nanoindentation hardness of the pressure-sensitive adhesive/adhesive layer may be, for example, 1.5 MPa or less, 1.0 MPa or less, 0.6 MPa or less, 0.55 MPa or less, or 0.25 MPa or less. The lower limit of the nanoindentation hardness of the pressure-sensitive adhesive/adhesive layer may be, for example, 0.11 MPa or more, 0.13 MPa or more, or 0.18 MPa or more. The nanoindentation hardness of the pressure-sensitive adhesive/adhesive layer may be, for example, 0.11 to 2.0 MPa, 0.13 to 2.0 MPa, 0.18 to 2.0 MPa, 0.10 to 1.5 MPa, 0.11 to 1.5 MPa, 0.13 to 1.5 MPa, 0.18 to 1.5 MPa, 0.10 to 1.0 MPa, 0.11 to 1.0 MPa, 0.13 to 1.0 MPa, 0.18 to 1.0 MPa, 0.10 to 0.6 MPa, 0.11 to 0.6 MPa, 0.13 to 0.6 MPa, 0.18 to 0.6 MPa, 0.10 to 0.55 MPa, 0.11 to 0.55 MPa, 0.13 to 0.55 MPa, 0.18 to 0.55 MPa, 0.10 to 0.25 MPa, 0.11 to 0.25 MPa, 0.13 to 0.25 MPa, or 0.18 to 0.25 MPa.

The laminate of the present disclosure may or may not necessarily include a component other than the first optical sheet and the pressure-sensitive adhesive/adhesive layer. The other component(s) is not particularly limited either, and is as described with reference to FIGs. 1A to 6C, for example. Further, the other component(s) may be any other component and may be, for example, an optical functional layer. The optical functional layer is also not particularly limited, and may be, for example, an optical functional layer used in a general optical film, such as a microlens film, a prism film, a diffusion film, a polarized reflection film, a polarizing film, a retardation film, a high refractive index layer, and the like.

In the laminate of the present disclosure, for example, the laminate of the first optical sheet and the pressure-sensitive adhesive/adhesive layer may have a light transmittance of 80% or more. For example, the haze of the laminate may be 3% or less. The light transmittance may be, for example, 82% or more, 84% or more, 86% or more, or 88% or more. The upper limit thereof is not particularly limited, but is ideally 100%, and may be, for example, 95% or less, 92% or less, 91% or less, or 90% or less. The haze of the laminate of can be measured, for example, by the same method as the method for measuring the haze of the void-containing layer to be described later. The light transmittance is a transmittance of light at a wavelength of 550 nm, and can be measured by, for example, the following measurement method.

Method for measuring light transmittance

A spectrophotometer "U-4100" (trade name, manufactured by Hitachi, Ltd.) is used, and the laminate is used as a sample to be measured. The total light transmittance (light transmittance) of the sample is measured with the total light transmittance of air being considered as 100%. The value of the total light transmittance (light transmittance) is a value measured at a wavelength of 550 nm.

In the laminate of the present disclosure, for example, the pressure-sensitive adhesive/adhesive layer has 180° peel pressure-sensitive adhesive force against PMMA (polymethyl methacrylate) (hereinafter merely referred to as the "PMMA pressure-sensitive adhesive force" or "PMMA adhesive force") of, for example, preferably 1.0 N/20mm or more. From the viewpoint of probability of peeling off during handling of the laminate of the present disclosure in attachment to other member(s) (e.g., other layer(s)), the PMMA adhesive force is preferably not too low. The PMMA adhesive force may be, for example, 2.0 N/20 mm or more, 3.0 N/20 mm or more, 4.0 N/20 mm or more, 5.0 N/20 mm or more, or 6.0 N/20 mm or more, and for example, 50 N/20 mm or less, 40 N/20 mm or less, 30 N/20 mm or less, 20 N/20 mm or less, or 10 N/20 mm or less. The PMMA adhesive force in the laminate of the present disclosure can be measured as follows, for example.

Method for measuring PMMA adhesive force

The laminate of the present disclosure is cut into a width of 20 mm, to expose the pressure-sensitive adhesive/adhesive arranged on the first main surface side of the first optical sheet. Thus-obtained test piece is to be subjected to the measurement of the PMMA adhesive force (mN/20mm). Alternatively, instead of the test piece, an alternative test piece produced as described below may be used similarly for the measurement of the PMMA adhesive force (mN/20mm). In a method for producing the alternative test piece, first, a pressure-sensitive adhesive/adhesive layer same as the pressure-sensitive adhesive/adhesive layer arranged on the first main surface of the first optical sheet of the laminate of the present disclosure is formed on one side of a separator film (e.g., a polyethylene terephthalate film treated with a silicone peeling agent: MRF38, manufactured by Mitsubishi Polyester Film Inc.). Then, thus-formed pressure-sensitive adhesive/adhesive layer is attached to a polyethylene terephthalate (PET) film (e,g., trade name "Lumirror S10", manufactured by Toray Industries, Inc) having a thickness of 25 $\mu$m. Thus-obtained laminate is cut into a width of 20 mm, the peeling-treated PET film is peeled off, and the surface of the exposed pressure-sensitive adhesive/adhesive layer is attached to a polymethyl methacrylate (PMMA) plate (e.g., trade name "SHINKOLITE", manufactured by Mitsubishi Chemical Corporation) to form the alternative test piece to be subjected to the measurement of the PMMA adhesive force (mN/20 mm). The method for measuring the PMMA adhesive force (mN/20 mm) is, specifically, performing press-bonding for the attachment to the PMMA plate by rolling with a 2 kg roller back and forth once, and 30 minutes after the attachment, the 180° peel pressure-sensitive adhesive force is measured using a tensile compression measuring instrument (trade name "AGS-50NX", manufactured by Shimadzu Corporation) under the following conditions. Thus-measured value of the peel pressure-sensitive adhesive force is defined as the the PMMA adhesive force.

Peeling speed: 300 mm/min
Measurement condition: temperature, 23±2°C; humidity, 65+5% RH

The laminate of the present disclosure may be formed on a substrate such as a film, for example. The film may be, for example, a resin film. In general, one having a relatively small thickness is sometimes called a "film" and one having a relatively large thickness is sometimes called a "sheet" for distinction. However, in the present disclosure, there is no particular distinction between a "film" and a "sheet".

The substrate is not particularly limited, and preferable examples thereof include thermoplastic resin substrates, glass substrates, inorganic substrates represented by silicon, plastics molded with thermosetting resins or the like, elements such as semiconductors, and carbon fiber-based materials represented by carbon nanotubes, but not limited thereto. Examples of the form of the substrate include a film and a plate. Examples of thermoplastic resin include polyethylene terephthalate (PET), acrylic resins, cellulose acetate propionate (CAP), cycloolefin polymer (COP), triacetylcellulose (TAC), polyethylene naphthalate (PEN), polyethylene (PE), and polypropylene (PP).

The optical member of the present disclosure is not particularly limited and may be, for example, an optical film including the laminate of the present disclosure.

The optical apparatus (optical device) of the present disclosure is not particularly limited and may be, for example, an image display or an illumination apparatus. Examples of the image display include a liquid crystal display, an organic Electro Luminescence (EL) display, and a micro Light Emitting Diode (LED) display. Examples of the illumination apparatus include an organic EL illumination apparatus.

[3. Pressure-sensitive adhesive/adhesive coating solution]

In the laminate of the present disclosure, the pressure-sensitive adhesive/adhesive layer can be formed using, for example, a pressure-sensitive adhesive/adhesive coating solution as described above. In the present disclosure, a "pressure-sensitive adhesive" and an "adhesive" are not always clearly distinguishable from each other, as will be described later. In the present disclosure, the term "pressure-sensitive adhesive/adhesive" includes both a "pressure-sensitive adhesive" and an "adhesive" unless otherwise specified. The pressure-sensitive adhesive/adhesive coating solution may include, for example, the (meth)acrylic polymer, may further include, for example, a crosslinking agent (e.g., an isocyanate-based crosslinking agent), and may further include, for example, a monomer having one or two reactive double bonds per molecule, and an organic peroxide. The pressure-sensitive adhesive/adhesive coating solution is not particularly limited, and is as exemplified as follows, for example.

In the pressure-sensitive adhesive/adhesive layer of the laminate of the present disclosure, the (meth)acrylic polymer may substantially exclude the (meth)acrylic polymer having a polystyrene-equivalent molecular weight of 100,000 or less.

In the laminate of the present disclosure, for example, the content of the (meth)acrylic polymer having a polystyrene-equivalent molecular weight of 100,000 or less in the (meth)acrylic polymer may be 10 wt% or less, 5 wt% or less, 1 wt% or less, 0.5 wt% or less, or less than 0.1 wt%. The lower limit value of the content of the (meth)acrylic polymer having a polystyrene-equivalent molecular weight of 100,000 or less in the (meth)acrylic polymer is not particularly limited and is, for example, 0 wt% (i.e., the (meth)acrylic polymer having a polystyrene-equivalent molecular weight of 100,000 or less is not included) or a value exceeding 0 wt%.

The laminate of the present disclosure, for example, may substantially exclude the (meth)acrylic polymer having a polystyrene-equivalent molecular weight of 30,000,000 or more.

In the laminate of the present disclosure, for example, the content of the (meth)acrylic polymer having a polystyrene-equivalent molecular weight of 30,000,000 or more in the (meth)acrylic polymer may be 10 wt% or less, 5 wt% or less, 1 wt% or less, 0.5 wt% or less, or less than 0.1 wt%. The lower limit value of the content of the (meth)acrylic polymer having a polystyrene-equivalent molecular weight of 30,000,000 or more in the (meth)acrylic polymer is not particularly limited and is, for example, 0 wt% (i.e., the (meth)acrylic polymer having a polystyrene-equivalent molecular weight of 30,000,000 or more is not included) or a value exceeding 0 wt%.

The (meth)acrylic polymer may include, for example, 1 to 30 wt%, preferably 3 to 25 wt% or 3 to 20 wt%, of a nitrogen-containing monomer as a monomer unit. The (meth)acrylic polymer may have, for example, a polydispersity (weight-average molecular weight (Mw)/number-average molecular weight (Mn)) of 3.0 or less. The lower limit value of the polydispersity is not particularly limited and is, for example, 1.0 or more, 1.5 or more, or 2.0 or more. The pressure-sensitive adhesive/adhesive coating solution may be, for example, a pressure-sensitive adhesive/adhesive coating solution including the (meth)acrylic polymer.

The pressure-sensitive adhesive/adhesive coating solution may include, for example, the (meth)acrylic polymer as a base polymer, wherein the (meth)acrylic polymer includes, for example, as monomer components, 3 to 20 wt% of a heterocycle-containing acrylic monomer, and a polymerizable functional group, and also includes 0.5 to 5 wt% of (meth)acrylic acid, 0.05 to 2wt% of hydroxyalkyl (meth)acrylate, and 83 to 96.45 wt% of alkyl (meth)acrylate.

As the heterocycle-containing acrylic monomer, for example, one having a polymerizable functional group and having a heterocyclic ring can be used without any particular limitation. Examples of the polymerizable functional group include a (meth)acryloyl group and a vinyl ether group. Among these, a (meth)acryloyl group is preferred. Examples of the heterocyclic ring include a morpholine ring, a piperidine ring, a pyrrolidine ring, and a piperazine ring. Examples of the heterocycle-containing acrylic monomer include N-acryloylmorpholine, N-acryloylpiperidine, N-methacryloylpiperidine, and N-acryloylpyrrolidine. Among these, N-acryloylmorpholine is preferable. The heterocycle-containing acrylic monomer can improve both the heat resistance and the moisture resistance in the case of thinning the pressure-sensitive adhesive layer (pressure-sensitive adhesive/adhesive layer). In the following description, N-acryloylmorpholine is sometimes referred to as "ACMO".

The heterocycle-containing acrylic monomer is preferable from the viewpoint of improving the pressure-sensitive adhesive force of the pressure-sensitive adhesive layer (pressure-sensitive adhesive/adhesive layer) to the optical film. In particular, the heterocycle-containing acrylic monomer is preferable from the viewpoint of improving the pressure-sensitive adhesive force to cyclic polyolefin such as a norbornene resin, and the heterocycle-containing acrylic monomer is suitable when a cyclic polyolefin is used as the optical film.

The heterocycle-containing acrylic monomer is used, for example, at the proportion of 3 to 20 wt% relative to the total amount of the monomer components forming the (meth)acrylic polymer. The proportion of the heterocycle-containing acrylic monomer may be, for example, 4 to 19 wt%, or 6 to 18 wt%. The proportion of the heterocycle-containing acrylic monomer is preferably not less than the aforementioned range from the viewpoints of the heat resistance and the moisture resistance in the case of thinning the pressure-sensitive adhesive layer (pressure-sensitive adhesive/adhesive layer). In addition, the proportion of the heterocycle-containing acrylic monomer is preferably not more than the aforementioned range, from the viewpoint of moisture resistance, in the case of thinning. The proportion of the heterocycle-containing acrylic monomer is preferably not more than the aforementioned range, from the viewpoint of improving the attachment ability of the pressure-sensitive adhesive layer (pressure-sensitive adhesive/adhesive layer). In addition, the proportion of the heterocycle-containing acrylic monomer is preferably not more than the aforementioned range, from the viewpoint of the moisture resistance in the case of thinning the pressure-sensitive adhesive layer (pressure-sensitive adhesive/adhesive layer).

The (meth)acrylic acids is preferably acrylic acid, in particular.

The (meth)acrylic acid is used, for example, at a proportion of 0.5 to 10 wt% relative to the total amount of the monomer components forming the (meth)acrylic polymer. The proportion of the (meth)acrylic acid may be, for example, 1 to 8 wt%, or 1.5 to 7 wt%. The proportion of the (meth)acrylic acid is preferably not less than the aforementioned range, from the viewpoint of the heat resistance in the case of thinning the pressure-sensitive adhesive layer (pressure-sensitive adhesive/adhesive layer). Also, the proportion of the (meth)acrylic acid is preferably not more than the aforementioned range, from the viewpoint of pressure-sensitive adhesive force.

As the hydroxyalkyl (meth)acrylate, for example, one having a polymerizable functional group and having a hydroxyl group can be used without any particular limitation. Preferable examples of the hydroxyalkyl (meth)acrylate include hydroxyalkyl (meth)acrylates such as 2-hydroxyethyl (meth)acrylate, 2-hydroxybutyl (meth)acrylate, 3-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, and 12-hydroxylauryl (meth)acrylate.

The hydroxyalkyl (meth)acrylate is used, for example, at a proportion of 0.05 to 2 wt% relative to the total amount of monomer components forming the (meth)acrylic polymer. The proportion of the hydroxyalkyl (meth)acrylate may be, for example, 0.075 to 1.5 wt%, or 0.1 to 1 wt%. The proportion of the hydroxyalkyl (meth)acrylate is preferably not less than the aforementioned range, from the viewpoint of the heat resistance in the case of thinning the pressure-sensitive adhesive layer (pressure-sensitive adhesive/adhesive layer). Also, the proportion of the hydroxyalkyl (meth)acrylate is preferably not more than the aforementioned range, from the viewpoint of pressure-sensitive adhesive force.

As the alkyl (meth)acrylate, for example, the alkyl group of the alkyl (meth)acrylate may have an average carbon number of around 1 to 12. The (meth)acrylate refers to acrylate and/or methacrylate, and (meth) in the present disclosure has the same meaning thereto. Specific examples of the alkyl (meth)acrylate include methyl (meth)acrylate, ethyl (meth)acrylate, n-butyl (meth)acrylate, 2-ethylhexyl (meth)acrylate, isooctyl (meth)acrylate, isononyl (meth)acrylate, and lauryl (meth)acrylate, which may be used alone or in combination. Among these, alkyl (meth)acrylate having C1-9 alkyl group is preferable.

The alkyl (meth)acrylate is used, for example, at a proportion of 83 to 96.45 wt% relative to the total amount of the monomer components forming the(meth)acrylic polymer. The alkyl (meth)acrylate is usually the balance excluding the heterocycle-containing acrylic monomer, (meth)acrylic acid, and hydroxyalkyl (meth)acrylate.

As the monomer component for forming the (meth)acrylic polymer, for example, in addition to the aforementioned monomers, any monomer other than those aforementioned can be used in a range of 10% or less of the total amount of the monomers, as long as the purpose of the present disclosure is not impaired.

Examples of such a monomer include acid anhydride group-containing monomers such as maleic anhydride and itaconic anhydride; a caprolactone adduct of acrylic acid; sulfonic acid group-containing monomers such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; and a phosphate group-containing monomer such as 2-hydroxyethyl acryloylylphosphate. Examples thereof also include nitrogen-containing vinyl monomers. For example, maleimide, N-cyclohexylmaleimide, N-phenylmaleimide; (N-substituted) amide-based monomers such as (meth)acrylamide, N, N-dimethyl (meth)acrylamide, N, N-diethyl (meth)acrylamide, N-hexyl (meth)acrylamide, N-methyl (meth)acrylamide, N-butyl (meth)acrylamide, N-butyl (meth)acrylamide and N-methylol (meth)acrylamide, and N-methylolpropane (meth)acrylamide; alkylaminoalkyl (meth)acrylate monomers such as aminoethyl (meth)acrylate, aminopropyl (meth)acrylate, N, N-dimethylaminoethyl (meth)acrylate, t-butylaminoethyl (meth)acrylate, and 3-(3- pyridinyl)propyl (meth)acrylate; alkoxyalkyl (meth)acrylate monomers such as methoxyethyl (meth)acrylate, and ethoxyethyl (meth)acrylate, and succinimide monomers such as N-(meth)acryloyloxymethylenesuccinimide, and N-(meth)acryloyl-6 oxyhexamethylenesuccinimide, N-(meth)acryloyl-8-oxyoctamethylene succinimide.

Vinyl monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic acid amides, styrene, $\alpha$-methylstyrene, and N-vinylcaprolactam; cyanoacrylate monomers such as acrylonitrile and methacrylonitrile; epoxy group-containing acrylic monomers such as glycidyl (meth)acrylate; glycol-based acrylic ester monomers such as polyethylene glycol (meth)acrylate, polypropylene glycol (meth)acrylate, methoxyethylene glycol (meth)acrylate, and methoxypolypropylene glycol (meth)acrylate; and acrylic acid ester monomers such as tetrahydrofurfuryl (meth)acrylate, fluorine (meth)acrylate, silicone (meth)acrylate, and 2-methoxyethyl acrylate can also be used.

Examples of the copolymerizable monomer other than those described above include silane monomers containing silicon atoms. Examples of the silane monomer include 3-acryloxypropyltriethoxysilane, vinyltrimethoxysilane, vinyltriethoxysilane, 4-vinylbutyltrimethoxysilane, 4-vinylbutyltriethoxysilane, 8-vinyloctyltrimethoxysilane, 8-vinyloctyltriethoxysilane, 10-methacryloyloxydecyltrimethoxysilane, 10-acryloyloxydecyltrimethoxysilane, 10-methacryloyloxydecyltriethoxysilane, and 10-acryloyloxydecyltriethoxysilane.

The (meth)acrylic polymer used in the pressure-sensitive adhesive/adhesive layer in the laminate of the present disclosure may have a weight-average molecular weight (Mw) of, for example, 700,000 to 4,000,000. The weight-average molecular weight may be, for example, 1,500,000 to 4,000,000, and for example, 1,800,000 to 3,800,000, 2,000,000 to 3,500,000, or 2,200,000 to 3,300,000. The weight-average molecular weight may also be, for example, 800,000 to 3,500,000, and for example, 1,500,000 to 3,400,000 or 2,000,000 to 3,300,000. The weight-average molecular weight is preferably not smaller than the aforementioned from the viewpoints of the heat resistance and the moisture resistance in the case of thinning the pressure-sensitive adhesive layer (pressure-sensitive adhesive/adhesive layer). Further, the weight-average molecular weight is preferably not larger than the aforementioned range, from the resistance, attachment ability, and pressure-sensitive adhesive force in the case of thinning. In the present disclosure, the weight-average molecular weight refers to a value measured by Gel Permeation Chromatography (GPC) and calculated in terms of polystyrene.

A method for producing such a (meth)acrylic polymer is not particularly limited, and known production methods such as solution polymerization, bulk polymerization, emulsion polymerization, and various radical polymerization can be appropriately selected. Further, the (meth)acrylic polymer obtained may be any of a random copolymer, a block copolymer, a graft copolymer, or the like.

In the solution polymerization, for example, ethyl acetate or toluene is used as a polymerization solvent. As a specific example of solution polymerization, the reaction is carried out by adding a polymerization initiator under an inert gas stream such as nitrogen, for example, at around 50 to 70°C for around 1 to 30 hours.

The polymerization initiator, the chain transfer agent, the emulsifier, and the like used in the radical polymerization are not particularly limited, and can be appropriately selected. The weight-average molecular weight of the (meth) acrylic polymer can be controlled by the amount of the polymerization initiator, or the chain transfer agent, and the amount thereof to be used is appropriately adjusted depending on the types of those.

Examples of the polymerization initiator include, but not limited to, azo-based initiators such as 2,2'-azobisisobutyronitrile, 2,2'-azobis(2-amidinopropane)dihydrochloride, 2,2'-azobis\[2-(5-methyl-2-imidazoline-2-yl)propane] dihydrochloride, 2,2'-azobis(2-methylpropionamidine)disulfate, 2,2'-azobis(N,N'-dimethyleneisobutylamidine), and 2,2'-azobis\[N-(2-carboxyethyl)-2-methylpropionamidine]hydrate (VA-057, manufactured by Wako Pure Chemical Industries, Ltd.); persulfates such as potassium persulfate and ammonium persulfate; peroxide -based initiators such as di(2-ethylhexyl)peroxydicarbonate, di(4-t-butylcyclohexyl)peroxydicarbonate, di-sec-butyl peroxydicarbonate, t-butyl peroxyneodecanoate, t-hexyl peroxypivalate, t-butyl peroxypivalate, dilauroyl peroxide, di-n-octanoyl peroxide, 1,1,3,3-tetramethylbutylperoxy-2-ethylhexanoate, di(4-methylbenzoyl)peroxide, dibenzoyl peroxide, t-butyl peroxyisobutyrate, 1,1-di(t-hexyl peroxy)cyclohexane, t-butyl hydroperoxide, and hydrogen peroxide; and redox initiators of a combination of peroxide and reducing agents, e.g., a combination of persulfate and sodium bisulfite and a combination of peroxide and sodium ascorbate.

One of the polymerization initiators may be used alone or two or more of them may be mixed to be use. The total content of the polymerization initiator may be, for example, around 0.005 to 1 pts.wt., or around 0.02 to 0.5 pts.wt., relative to 100 pts.wt. of the monomer.

When producing the (meth)acrylic polymer having the weight-average molecular weight using, for example, 2,2'-azobisisobutyronitrile as the polymerization initiator, the amount of the polymerization initiator used may be, for example, around 0.06 to 0.2 pts.wt., or around 0.08 to 0.175 pts.wt., relative to 100 pts.wt. of the total monomer components.

Examples of the chain transfer agent include lauryl mercaptan, glycidyl mercaptan, mercaptoacetic acid, 2-mercaptoethanol, thioglycolic acid, 2-ethylhexyl thioglycolate, and 2,3-dimercapto-1-propanol. One of the chain transfer agents may be used alone or two or more of them may be mixed to be used. The total content of the chain transfer agent is, for example, around 0.1 pts.wt. or less relative to 100 pts.wt. of the total monomer components.

Examples of the emulsifier used in the emulsion polymerization include anionic emulsifiers such as sodium lauryl sulfate, ammonium lauryl sulfate, sodium dodecylbenzene sulfonate, ammonium polyoxyethylene alkyl ether sulfate, and sodium polyoxyethylene alkyl phenyl ether sulfate; and nonionic emulsifiers such as polyoxyethylene alkyl ether, polyoxyethylene alkyl phenyl ether, polyoxyethylene fatty acid ester, and polyoxyethylene-polyoxypropylene block polymer. One of the emulsifiers may be used alone or two or more of them may be used in combination.

Further, specific examples of the emulsifier, into which a radically polymerizable functional group such as a propenyl group or an allyl ether group is introduced as a reactive emulsifier, include Akuaron HS-10, HS-20, KH-10, BC-05, BC-10, and BC-20 (all of which are manufactured by DKS Co., Ltd.) and ADEKA REASOAP SE10N (manufactured by ADEKA CORPORATION). Since the reactive emulsifier is incorporated into the polymer chain after the polymerization, the water resistance is improved, which is preferable. The amount of the emulsifier used is, preferably 0.3 to 5 pts.wt., and more preferably 0.5 to 1 pts.wt. for better polymerization stability and mechanical stability, relative to 100 pts.wt. of the total monomer components.

The content of the (meth)acrylic polymer in the pressure-sensitive adhesive/adhesive coating solution is not particularly limited, and may be, for example, 3 mass% or more, or 5 mass% or more, and for example, 30 mass% or less, 20 mass% or less, or 10 mass% or less, relative to the total mass of the pressure-sensitive adhesive/adhesive coating solution.

The pressure-sensitive adhesive/adhesive coating solution may or may not necessarily include a monomer having one or two reactive double bonds per molecule. The monomer having one or two reactive double bonds per molecule is not particularly limited, and examples thereof include acrylic monomers, vinyl-based monomers, methacrylic monomers, and allyl-based monomers, and acrylic monomers are more preferable, from the viewpoint of the reaction rate of the graft reaction. The acrylic monomer is not particularly limited and may be, for example, the same as the monomer exemplified as the monomer component of the acrylic polymer. In the monomer having one or two reactive double bonds per molecule, the structure of the side chain is not particularly limited, and a heterocycle-containing monomer is preferable from the viewpoint of achieving a high elastic modulus within a proper range and a reduction in the amount of the semi-polymeric polymer at the same time.

When the pressure-sensitive adhesive/adhesive coating solution includes the monomer having one or two reactive double bonds per molecule, the content thereof is not particularly limited and may be, in the pressure-sensitive adhesive/adhesive coating solution, for example, 0.1 mass% or more, 0.5 mass% or more, or 1 mass% or more, and for example, 30 mass% or less, 20 mass% or less, or 10 mass% or less, relative to the total mass of the (meth)acrylic polymer.

The pressure-sensitive adhesive/adhesive coating solution may or may not necessarily include, for example, a crosslinking agent, as described above. The crosslinking agent is not particularly limited, and examples thereof include an isocyanate-based crosslinking agent and an epoxy-based crosslinking agent. The isocyanate-based crosslinking agent is not particularly limited, and examples thereof include aromatic isocyanates such as tolylene diisocyanate, xylene diisocyanate, and the like, alicyclic isocyanates such as isophorone diisocyanate and the like, and aliphatic isocyanates such as hexamethylene diisocyanate and the like. The epoxy-based crosslinking agent is not particularly limited, and examples thereof include a bisphenol A epichlorohydrin type epoxy resin, ethylene glycol diglycidyl ether, polyethylene glycol diglycidyl ether, glycerin diglycidyl ether, glycerin triglycidyl ether, 1,6-hexanediol diglycidyl ether, trimethylolpropane triglycidyl ether, sorbitol polyglycidyl ether, polyglycerol polyglycidyl ether, pentaerythritol polyglycidyl erythritol, diglycerol polyglycidyl ether, 1,3'-bis(N,N-diglycidylaminomethyl)cyclohexane, and N,N,N', N'-tetraglycidyl-m-xylenediamine.

Specific examples of the isocyanate-based crosslinking agent include lower aliphatic polyisocyanates such as butylenediisocyanate and hexamethylene diisocyanate; alicyclic isocyanates such as cyclopentylene diisocyanate, cyclohexylene diisocyanate, and isophorone diisocyanate; aromatic diisocyanates such as 2,4-tolylene diisocyanate, 4,4'-diphenylmethane diisocyanate, xylylene diisocyanate, and polymethylene polyphenyl isocyanate; isocyanate adducts such as a trimethylolpropane/tolylene diisocyanate trimer adduct ("CORONATE® L" (trade name), manufactured by Nippon Polyurethane Industry Co., Ltd.), a trimethylolpropane/hexamethylene diisocyanate trimer adduct ("CORONATE® HL" (trade name), manufactured by Nippon Polyurethane Industry Co., Ltd.), and isocyanurate form of hexamethylene diisocyanate ("CORONATE® HX" (trade name), manufactured by Nippon Polyurethane Industry Co., Ltd.); polyether polyisocyanate; polyester polyisocyanate; and adducts of these with various polyols, and polyisocyanates multifunctionalized with isocyanurate bonds, biuret bonds, allophanate bonds, and the like.

More specifically, examples of the epoxy-based crosslinking agent include "TETRAD-C" manufactured by MITSUBISHI GAS CHEMICAL COMPANY, INC., "TETRAD-X" manufactured by MITSUBISHI GAS CHEMICAL COMPANY, INC., and "S-610" manufactured by Synasia Inc.

The crosslinking agent (e.g., an isocyanate-based crosslinking agent or an epoxy-based crosslinking agent) may be used alone or in combination of two or more kinds thereof, and the total content may be, for example, 0.02 to 2 pts.mass, 0.04 to 1.5 pts.mass, or 0.05 to 1 pts.mass, relative to 100 pts.mass of the (meth)acrylic polymer. The content of the isocyanate-based crosslinking agent is preferably 0.02 pts.mass or more, from the viewpoint of cohesion. On the other hand, the content of the isocyanate-based crosslinking agent is preferably 2 pts.mass or less, from the viewpoint of suppression or prevention of decrease in adhesive force due to excessive crosslinking formation. The content of the epoxy-based crosslinking agent is preferably 0.01 pts.mass or more, from the viewpoint of the void-remaining rate. On the other hand, the content of the epoxy-based crosslinking agent is preferably 1.0 pts.mass or less, from the viewpoint of peel durability.

In the pressure-sensitive adhesive/adhesive coating solution, the crosslinking agent may be formed only of the isocyanate-based crosslinking agent, for example, or may or may not necessarily further include a crosslinking agent other than the isocyanate-based crosslinking agent. Examples of the other crosslinking agent(s) include an organic crosslinking agent and a polyfunctional metal chelate. Examples of the organic crosslinking agent include an epoxy-based crosslinking agent and an imine-based crosslinking agent. The organic crosslinking agent is preferably an isocyanate-based crosslinking agent or an epoxy-based crosslinking agent. In the polyfunctional metal chelate, a polyvalent metal is covalently or coordinatively bonded to an organic compound. Examples of the polyvalent metal atom include Al, Cr, Zr, Co, Cu, Fe, Ni, V, Zn, In, Ca, Mg, Mn, Y, Ce, Sr, Ba, Mo, La, Sn, and Ti. Examples of the atom in the organic compound which forms a covalent bond or a coordinate bond include an oxygen atom, and examples of the organic compound include an alkyl ester, an alcohol compound, a carboxylic acid compound, an ether compound, and a ketone compound.

The pressure-sensitive adhesive/adhesive coating solution may or may not necessarily include an organic peroxide, for example. The organic peroxide is not particularly limited, and examples thereof include di(2-ethylhexyl) peroxydicarbonate, di(4-t-butylcyclohexyl) peroxydicarbonate, di-sec-butyl peroxydicarbonate, t-butyl peroxyneodecanoate, t-hexyl peroxypivalate, t-butyl peroxypivalate, dilauroyl peroxide, di-n-octanoyl peroxide, 1,1,3,3-tetramethylbutyl peroxy-2-ethylhexanoate, di(4-methylbenzoyl) peroxide, dibenzoyl peroxide, t-butyl peroxyisobutyrate, 1,1-di(t-hexylperoxy) cyclohexane, and t-butyl hydroperoxide. The organic peroxide may be used alone or in combination of two or more kinds.

When the pressure-sensitive adhesive/adhesive coating solution includes the organic peroxide, the content of the organic peroxide is not particularly limited. In the pressure-sensitive adhesive/adhesive coating solution, the content of the organic peroxide may be, for example, 0.02 mass% or more, 0.1 mass% or more, 0.5 mass% or more, 1 mass% or more, or 2.5 mass% or more, and for example, 20 mass% or less, 10 mass% or less, 8 mass% or less, or 6 mass% or less, relative to the total mass of the (meth)acrylic polymer.

The pressure-sensitive adhesive/adhesive coating solution may further include a solvent or the like. The solvent is not particularly limited, and for example, a polymerization solvent used in solution polymerization in the production of the (meth)acrylic polymer may be used as it is.

Further, the pressure-sensitive adhesive/adhesive coating solution may appropriately use, as needed, tackifiers, plasticizers, fillers formed of glass fibers, glass beads, metal powders, or other inorganic powders, pigments, colorants, fillers, antioxidants, ultraviolet absorbers, silane coupling agents, or the like, and various additives within a range that does not deviate from the purpose of the present disclosure. Further, the pressure-sensitive adhesive layer (pressure-sensitive adhesive/adhesive layer) may include fine particles and exhibit light diffusibility.

The pressure-sensitive adhesive/adhesive layer in the laminate of the present disclosure can be formed using the pressure-sensitive adhesive/adhesive coating solution, for example, by a method described later. The sol component of pressure-sensitive adhesive/adhesive layer may have a weight-average molecular weight of 30,000 to 600,000, for example, in molecular weight measurement of the pressure-sensitive adhesive/adhesive layer by gel permeation chromatography. Further, for example, in the molecular weight measurement of the pressure-sensitive adhesive/adhesive layer by gel permeation chromatography, the content of the low molecular weight component having a molecular weight of 10,000 or less in the sol component of the pressure-sensitive adhesive/adhesive layer may be 20 wt % (mass %) or less. When the weight-average molecular weight of the sol component or the content of the low molecular-weight component having a molecular weight of 10,000 or less in the sol component is in the aforementioned specific range, the pressure sensitive adhesive is more less likely to permeate into the voids of the void-containing layer. The weight-average molecular weight of the sol component may be, for example, 50,000 or more, and for example, 550,000 or less or 500,000 or less, and for example, 50,000 to 550,000 or 60,000 to 500,000. The content (proportion) of the component having a molecular weight of 10,000 or less in the sol component may be, for example, 20 wt% or less as described above, and for example, 15 wt% or less or 10 wt% or less, relative to the total sol component (100 wt%). The lower limit value of the content (proportion) of the component having a molecular weight of 10,000 or less in the sol component is not particularly limited, and may be, for example, 0 wt% or more or more than 0 wt%, and for example, 3 wt% or more. The content (proportion) of the component having a molecular weight of 10,000 or less in the sol component may be, for example, 3 to 15 wt% or 3 to 10 wt%.

[4. Method for producing laminate]

A method for producing the laminate of the present disclosure is not particularly limited, and for example, the laminate can be produced by the production method described below. However, the following description is illustrative and by no means limit the present disclosure.

The method for producing the laminate of the present disclosure includes, as described above, attaching the pressure-sensitive adhesive/adhesive layer and the first main surface of the first optical sheet (hereinafter sometimes referred to as the "attaching"). However, the method for producing the laminate of the present disclosure is not limited thereto. For example, instead of the attaching the pressure-sensitive adhesive/adhesive layer and the first main surface of the first optical sheet, the pressure-sensitive adhesive/adhesive layer may be formed by applying a pressure-sensitive adhesive/adhesive to the first main surface of the first optical sheet. However, from the viewpoint of suppressing the intrusion of the pressure-sensitive adhesive/adhesive into the recessed portions of the first main surface, the attaching is more preferable than the forming the pressure-sensitive adhesive/adhesive layer by applying the pressure-sensitive adhesive/adhesive to the first main surface.

In addition, the method for producing the laminate of the present disclosure (e.g., the method for producing the laminate according to the present disclosure) may further include, for example, producing the pressure-sensitive adhesive/adhesive layer. The method for producing the pressure-sensitive adhesive/adhesive layer may include, for example, coating a substrate with the pressure-sensitive adhesive/adhesive coating solution, and heat-drying the substrate coated with the pressure-sensitive adhesive/adhesive coating solution. For example, the pressure-sensitive adhesive/adhesive layer side of an adhesive tape or the like, in which the pressure-sensitive adhesive/adhesive layer of the present disclosure is laminated on a substrate, may be attached onto the first optical sheet of the present disclosure, to form the pressure-sensitive adhesive/adhesive layer on the first optical sheet of the present disclosure. In this case, the substrate of the adhesive tape may be left on or peeled off from the pressure-sensitive adhesive/adhesive layer. In particular, peeling off the substrate to obtain the pressure-sensitive adhesive/adhesive sheet including the first optical sheet with no substrate (substrateless) allows significant reduction in the thickness and thus can suppress an increase in the thickness of the device or the like. In the present disclosure, the "pressure-sensitive adhesive" and the "pressure-sensitive adhesive layer" refer to, for example, an agent or a layer that is supposed to be re-peeled from an adherend. In the present disclosure, the "adhesive" and the "adhesive layer" refer to, for example, an agent or a layer that is not supposed to be re-peeled from an adherend. However, in the present disclosure, a "pressure-sensitive adhesive" and an "adhesive" are not always clearly distinguishable from each other, and the "pressure-sensitive adhesive layer" and the "adhesive layer" are not always clearly distinguishable from each other. In the present disclosure, the pressure-sensitive adhesive/adhesive layer can be produced, for example, using the pressure-sensitive adhesive/adhesive coating solution as described above.

The producing the pressure-sensitive adhesive/adhesive layer can be performed, for example, as follows. First, the pressure-sensitive adhesive/adhesive coating solution is produced by mixing all components of the pressure-sensitive adhesive/adhesive coating solution. The pressure-sensitive adhesive/adhesive coating solution may include, for example, the (meth)acrylic polymer as described above, and may or may not necessarily further include a crosslinking agent (e.g., isocyanate-based crosslinking agent or epoxy-based crosslinking agent), for example. The pressure-sensitive adhesive/adhesive coating solution may include, for example, the (meth)acrylic polymer, a monomer having one or two reactive double bonds per molecule, a crosslinking agent, and an organic peroxide. In this case, when the pressure-sensitive adhesive/adhesive coating solution includes a component(s) other than these, such a component(s) may be mixed together. For example, the polymerization solvent at the time of producing the (meth)acrylic polymer may be mixed as a component of the pressure-sensitive adhesive/adhesive coating solution, without being removed. The method for producing the pressure-sensitive adhesive/adhesive coating solution may or may not necessarily include a process other than the mixing, and may be simply mixing all the components of the pressure-sensitive adhesive/adhesive coating solution in the mixing.

Next, the pressure-sensitive adhesive/adhesive coating solution is applied to a substrate (applying a pressure-sensitive adhesive/adhesive coating solution). The substrate is not particularly limited, and may be, for example, a base such as a film. Preferable examples of the substrate include, but not limited to, thermoplastic resin substrates, glass substrates, inorganic substrates represented by silicon, plastics molded with thermosetting resins or the like, elements such as semiconductors, and carbon fiber-based materials represented by carbon nanotubes. Examples of the form of the base include a film and a plate. Examples of thermoplastic resin include polyethylene terephthalate (PET), acrylic resins, cellulose acetate propionate (CAP), cycloolefin polymer (COP), triacetylcellulose (TAC), polyethylene naphthalate (PEN), polyethylene (PE), and polypropylene (PP). In the coating the pressure-sensitive adhesive/adhesive coating solution, the coating thickness of the pressure-sensitive adhesive/adhesive coating solution is not particularly limited, and may be appropriately adjusted so that, for example, the thickness of the dried pressure-sensitive adhesive/adhesive layer be a predetermined thickness. The thickness of the dried pressure-sensitive adhesive/adhesive layer is not particularly limited either, and is, for example, as described later.

Next, the substrate coated with the pressure-sensitive adhesive/adhesive coating solution is heated and dried (heating and drying the substrate). In the heating and drying the substrate, the heating and drying temperature is not particularly limited and may be, for example, 50°C or more, 80°C or more, 100°C or more, or 155°C or more, and for example, 200°C or less, 180°C or less, or 160°C or less. The heating and drying time is not particularly limited and may be, for example, 0.5 minutes or more, 1 minute or more, or 3 minutes or more, and for example, 60 minutes or less, 30 minutes or less, 20 minutes or less, or 10 minutes or less. In the heating and drying, for example, a crosslinking reaction and graft polymerization occur between the (meth)acrylic polymer and the crosslinking agent. As a result, for example, the amount of the semi-polymeric polymer present in the pressure-sensitive adhesive/adhesive coating solution reduces, making the pressure-sensitive adhesive/adhesive layer less liable to intrude into the recessed portions of the first optical sheet, as described above. In this way, the pressure-sensitive adhesive/adhesive layer used in the laminate of the present disclosure can be produced.

Next, as described above, the pressure-sensitive adhesive/adhesive layer and the first main surface of the first optical sheet are attached together (attaching). A method of the attaching is not particularly limited, and for example, the pressure-sensitive adhesive/adhesive layer side of an adhesive tape or the like, in which the pressure-sensitive adhesive/adhesive layer of the present disclosure is laminated on a substrate, is attached onto the first optical sheet of the present disclosure, to form the pressure-sensitive adhesive/adhesive layer on the first optical sheet of the present disclosure, as described above. In this way, the laminate of the present disclosure can be produced.

The thickness of the pressure-sensitive adhesive/adhesive layer is not particularly limited and is, for example, 0.1 to 100 $\mu$m, 5 to 50 $\mu$m, 10 to 30 $\mu$m, or 12 to 25 $\mu$m.

Thus-obtained laminate of the present disclosure may be, for example, further laminated with other film(s) (layer) to form a laminated structure including the first optical sheet, as described above. In this case, in the laminated structure, respective constituent element may be, for example, laminated via the pressure-sensitive adhesive/adhesive layer (pressure-sensitive adhesive or adhesive), as described above.

The lamination of the respective constituent element may be performed, for example, by a continuous treatment using a long film (so-called Roll to Roll or the like) as described above, because of its efficiency. When the substrate is a molded product, element, or the like, a batch-treated constituent element may be laminated.

Examples

Next, Examples of the present disclosure will be described. Note that, the present disclosure is not limited to the following Examples.

Note that, in the following Reference Examples, Examples, and Comparative Examples, the number of parts of each substance (relative amount to be used) is parts by mass (parts by weight), unless otherwise specified. In the following Reference Examples, Examples, and Comparative Examples, a pressure-sensitive adhesive (pressure-sensitive adhesive composition) described later is used as a pressure-sensitive adhesive/adhesive. In the following Reference Examples, Examples and Comparative Examples, a "pressure-sensitive adhesive layer" corresponds to a "pressure-sensitive adhesive/adhesive layer". That is, in the following Reference Examples, Examples and Comparative Examples, the "pressure-sensitive adhesive layer" and the "pressure-sensitive adhesive/adhesive layer" have the same meaning unless otherwise specified.

In the following Reference Examples, Examples, and Comparative Examples, the molecular weight of the (meth) acrylic polymer, the weight-average molecular weight (Mw) of the (meth)acrylic polymer, the thickness of each layer, the gel fraction of the pressure-sensitive adhesive/adhesive layer, the weight-average molecular weight (Mw) of the sol component of the pressure-sensitive adhesive/adhesive layer, the nanoindentation hardness, and the PMMA adhesive force (180° peel pressure-sensitive adhesive force to polymethyl methacrylate) were respectively measured by the following measurement methods.

Method for measuring molecular weight of (meth)acrylic polymer

From the molecular weight distribution curve measured by Gel Permeation Chromatography (GPC), the weight-average molecular weight (Mw) of the (meth)acrylic polymer, the polydispersity (Mw/Mn), the proportion (weight percentage) of the low molecular weight component having a molecular weight of 100,000 or less, and the proportion (weight percentage) of the high molecular weight component having a molecular weight of 30 million or more were calculated.

· Analyzing device: Waters, Alliance

· Column: G7000HXL + GMHXL + GMHXL manufactured by Tosoh Corporation · Column size: 7.8 mm $\varphi \times$ 30 cm each, total 90 cm

· Column temperature: 40°C

· Flow rate: 0.8 mL/min

· Injection volume: 100 $\mu$L

· Eluent: THF (added with acid)

· Detector: differential refractometer (RI)

· Standard sample: polystyrene

Method for measuring thickness

The thicknesses of the pressure-sensitive adhesive layer at five points were measured using a dial gauge, and the average value was used as the thickness. A thick part with different contrast present between the pressure-sensitive adhesive layer and the low-refractive-index layer in an SEM image was considered as an intermediate layer. The thicknesses of the intermediate layer at two points read in the SEM image was used as the thickness of the intermediate layer.

Method for measuring weight-average molecular weight (Mw) of (meth)acrylic polymer

The weight-average molecular weight (Mw) of the (meth)acrylic polymer was measured by Gel Permeation Chromatography (GPC) under the following conditions. The polydispersity (Mw/Mn) of the (meth)acrylic polymer was also measured in the same manner.

· Analyzer: Alliance, manufactured by Waters
· Column: G7000HXL + GMHXL + GMHXL manufactured by Tosoh Corporation · Column size: 7.8 mm φ × 30 cm each, total 90 cm
· Column temperature: 40°C
· Flow rate: 0.8 mL/min
· Injection volume: 100 μL
· Eluent: THF (added with acid)
· Detector: differential refractometer (RI)
· Standard sample: polystyrene

Method for measuring gel fraction of pressure-sensitive adhesive/adhesive layer

Around 0.1 g was scraped off from the pressure-sensitive adhesive/adhesive composition layer to obtain a sample 1. The sample 1 was wrapped in a TEFLON® (registered trademark) film (trade name "NTF1122", manufactured by Nitto Denko Corporation) having a diameter of 0.2 μm and bound with a kite string to obtain a sample 2. The weight of the sample 2 before being subjected to the following test was measured, and the measured weight was defined as weight A. The weight A is the total weight of the sample 1 (pressure-sensitive adhesive layer), the TEFLON® (registered trademark) film, and the kite thread. The total weight of the TEFLON® (registered trademark) film and the kite string was defined as weight B. Then, the sample 2 was placed in a 50 ml container filled with ethyl acetate and allowed to stand at 23°C for 1 week. Thereafter, the sample 2 was taken out from the container and dried in a dryer at 130°C for 2 hours to remove the ethyl acetate, and then the weight of the sample 2 was measured. The weight of the sample 2 after being subjected to the above test was measured, and the measured weight was defined as weight C. Then, the gel fraction was calculated from the following formula.

$$\text{Gel fraction (\%)} = (C - B) / (A - B) \times 100$$

Method for measuring weight-average molecular weight (Mw) of sol component of pressure-sensitive adhesive/adhesive layer

The weight-average molecular weight (Mw) of the sol component in the pressure-sensitive adhesive layer was measured by Gel Permeation Chromatography (GPC) under the following conditions. The pressure-sensitive adhesive layer was immersed in 10 mM-phosphoric acid/tetrahydrofuran overnight to extract the sol component. At this time, in consideration of the gel fraction of the pressure-sensitive adhesive layer, the content of the sol component of the solution after the extraction was adjusted to 0.1 wt %. The extracted solution was filtered with a 0.45-μm membrane filter, and the obtained filtrate was subjected to GPC measurement.

· Analyzer: Alliance, manufactured by Waters

· Column: G7000HXL + GMHXL + GMHXL manufactured by Tosoh Corporation · Column size: 7.8 mm φ × 30 cm each, total 90 cm

· Column temperature: 40°C

· Flow rate: 0.8 mL/min

· Injection volume: 100 μL

· Eluent: 10 mM-phosphoric acid/tetrahydrofuran

· Detector: differential refractometer (RI)

· Standard sample: polystyrene

Method for measuring nanoindentation hardness

The sample for measurement was cut into a piece with about 1 cm per side and fixed to a predetermined support, and the nanoindentation hardness of the pressure-sensitive adhesive layer was measured under the following conditions. The nanoindentation hardness was measured by the nanoindentation method.

· Analyzer: Triboindenter, manufactured by Hysitron Inc.
· Indenter: Conical (spherical shape: 20 μm in diameter)
· Measurement method: single indentation measurement
· Temperature: room temperature
· Indentation depth: 2000 nm

From the measured maximal load (Pmax) and contact-projected area (A), the nanoindentation hardness was calculated by the following formula.

$$\text{Nanoindentation hardness} = P_{max}/A$$

In the present example, the nanoindentation hardness of the surface of the pressure-sensitive adhesive layer was measured, and there was no difference in the measured value on the cross section of the pressure-sensitive adhesive layer.

Method for measuring PMMA adhesive force

PMMA adhesive force, i.e., 180° peel pressure-sensitive adhesive force to PMMA (polymethyl methacrylate), was measured as follows. First, the laminate (having a laminated structure of a separator film/an pressure-sensitive adhesive/adhesive layer) in which a pressure-sensitive adhesive layer (pressure-sensitive adhesive/adhesive layer) is formed on a surface of a separator film (polyethylene terephthalate film treated with a silicone-based peeling agent: MRF38, manufactured by Mitsubishi Polyester Film Inc.) produced in each of Examples and Comparative Examples described later was subjected to attachment, by attaching the pressure-sensitive adhesive/adhesive layer side on a polyethylene terephthalate (PET) film (trade name "Lumirror S10", manufactured by Toray Industries Inc.) having a thickness of 25 μm. Thus-obtained laminate was cut into a width of 20 mm, the PET film was peeled off, and the surface of the exposed pressure-sensitive adhesive layer was attached to a polymethyl methacrylate (PMMA) plate (e.g., trade name "SHINKOLITE", manufactured by Mitsubishi Chemical Corporation) to form a test piece to be subjected to the measurement of the PMMA adhesive force (mN/20 mm). Specifically, press-bonding for the attachment to the PMMA plate was performed by rolling with a 2 kg roller back and forth once, and 30 minutes after the attachment, 180° peel pressure-sensitive adhesive force was measured using a tensile compression measuring instrument (trade name "AGS-50NX", manufactured by Shimadzu Corporation) under the following conditions. Thus-measured value of the peel pressure-sensitive adhesive force was defined as the PMMA adhesive force.

Peeling speed: 300 mm/min
Measurement condition: temperature, 23±2°C; humidity, 65±5% RH

The measured value (mN/20mm) of the peel pressure-sensitive adhesive force (PMMA adhesive force) obtained by the above measurement method was evaluated in four grades as follows.

Poor: Less than 1.0 mN/20 mm
Fair: 1.0 mN/20 mm or more and less than 2.0 mN/20 mm
Good: 2.0 mN/20 mm or more and less than 6.0 mN/20 mm
Excellent: 6.0 mN/20 mm or more

Method for measuring and calculating air cavity-remaining rate

In each of the Examples and Comparative Examples described later, the shape of the air cavity (the recessed portion in the first optical sheet) of the laminate having the laminated structure of a uneven-shaped film (the first optical sheet)/a pressure-sensitive adhesive layer (pressure-sensitive adhesive/adhesive layer)/an acrylic resin film, was observed and measured with a laser microscope (VK-X1100, manufactured by Keyence Corporation). Further, the shape of the air cavity (the recessed portion in the first optical sheet) of the uneven-shaped film (the first optical sheet) alone was also observed and measured with the same apparatus and method. Then, the air cavity-remaining rate was calculated by the following formula (1).

$$R = (L1/L2) \times 100 \ (1)$$

In the formula (1), R represents the air cavity-remaining rate (%). L1 represents a measured value of the length of the long side of the air cavity (the recessed portion in the first optical sheet) in the laminate. L2 represents a measured value of the length of the long side of the air cavity (the recessed portion in the first optical sheet) of the uneven-shaped film (the first optical sheet) alone.

In the pressure-sensitive adhesive/adhesive layer in each of the following Reference Examples, Examples and Comparative examples, it is presumed that the polymer (acrylic polymer) was crosslinked by the crosslinking agent through heating and drying of the coated pressure-sensitive adhesive, and formed a crosslinked structure, but the crosslinked structure was not examined.

[Reference Example 1: Preparation of acrylic polymer (A1)]

A monomer mixture including 83 parts of butyl acrylate, 13 parts of N-acryloylmorpholine, 3 parts of acrylic acid and 1 part of 4-hydroxybutyl acrylate was charged into a four-neck flask equipped with a stirring blade, a thermometer, a nitrogen gas introduction tube, and a condenser. Further, 0.06 parts of 2,2'-azobisisobutyronitrile as a polymerization initiator and 50 parts of ethyl acetate, relative to 100 parts of the monomer mixture, were charged together, and nitrogen gas was introduced thereto while gentle stirring for replacement with nitrogen. A polymerization reaction was carried out for 3 hours while maintaining the liquid temperature in the flask at about 55°C to prepare a solution of acrylic polymer (A1) with a weight-average molecular weight (Mw) of 3,000,000 and Mw/Mn=2.8.

[Reference Example 2: Preparation of acrylic polymer (A2)]

The composition of the monomer mixture in Reference Example 1 (preparation of (meth)acrylic polymer (A1)) was changed to 73 parts of butyl acrylate, 20 parts of N-acryloyl morpholine, 6 parts of acrylic acid, and 1 part of 4-hydroxybutyl acrylate. A solution of (meth)acrylic polymer (A3) with a weight-average molecular weight (Mw) of 2,500,000 and Mw/Mn=2.4 was prepared in the same manner as in Reference Example 1, except for the above changes.

[Reference Example 3: Preparation of (meth)acrylic polymer (A3)]

The composition of the monomer mixture in Reference Example 1 (preparation of (meth)acrylic polymer (A1)) was changed to 95 parts of butyl acrylate, 1 part of N-acryloyl morpholine, 3 parts of acrylic acid, and 1 part of 4-hydroxybutyl acrylate, and the polymerization reaction time was changed to 8 hours. A solution of (meth)acrylic polymer (A3) with a weight-average molecular weight (Mw) of 1,700,000 and Mw/Mn=5.2 was prepared in the same manner as in Reference Example 1, except for the above changes.

[Reference Example 4: Preparation of (meth)acrylic polymer (A4)]

The composition of the monomer mixture in Reference Example 1 (preparation of (meth)acrylic polymer (A1)) was changed to 63 parts of butyl acrylate, 30 parts of N-acryloyl morpholine, 6 parts of acrylic acid, and 1 part of 4-hydroxybutyl acrylate. A solution of (meth)acrylic polymer (A4) with a weight-average molecular weight (Mw) of 2,300,000 and Mw/Mn=2.8 was prepared in the same manner as in Reference Example 1, except for the above changes.

[Reference Example 5: Production of uneven-shaped film (first optical sheet)]

An uneven-shaped film was produced according to the method described in JP-T-2013-524288. Specifically, first, a surface of a PMMA (polymethyl methacrylate) film (trade name: LPV90-0.01S, manufactured by Nihon Tokushu Kogaku Jushi Co., Ltd.) was coated with lacquer (trade name: "FINECURE RM-64", manufactured by Sanyo Chemical Industries, Ltd.). An optical pattern was embossed on the film surface including the lacquer. Thereafter, the lacquer was cured, thereby producing the desired uneven-shaped film (first optical sheet). The total thickness of thus-obtained uneven-shaped film was 125 $\mu$m, and the haze value thereof was 0.8%.

FIG. 5A shows a plan view of a part of the produced uneven-shaped film (first optical sheet) viewed from the uneven surface (first main surface) side. FIG. 5B shows cross-sectional view taken along the 8B-8B' line of the uneven-shaped film of FIG. 5A. As shown in FIG. 5A, this uneven-shaped film had a plurality of recessed portions 74 respectively having a triangular cross section with a length L of 80 $\mu$m, a width W of 17.3 $\mu$m, and a depth H of 10 $\mu$m, arranged at intervals of width E (260 $\mu$m) in the X direction. Further, such patterns of the recessed portions 74 were arranged at intervals of width D (160 $\mu$m) in the Y direction. In FIG. 5A, Px was 340 $\mu$m and Py was 174 $\mu$m. The density of recessed portions 74 on the surface of the uneven-shaped film was 2426/cm$^2$. In FIG. 5B, the inclination angle $\theta$a was around 60°, and the inclination angle $\theta$b was 85°. The area occupancy ratio of the recessed portions 74 when the film was planarly viewed from the uneven-shaped surface side was 3.4%.

[Example 1: Production of laminate]

A laminate of Example 1 was produced by the following method.

(1) Preparation of pressure-sensitive adhesive composition

Relative to 100 parts in terms of solid content of the (meth)acrylic polymer (A1) solution prepared (produced) in Reference Example 1, 0.3 parts of an isocyanate crosslinking agent (trade name "CORONATE L", manufactured by Nippon Polyurethane Industry Co.,Ltd., adduct of trimethylolpropane and tolylene diisocyanate) and 0.1 pts.mass of 1,3-bis(N,N-diglycidylaminomethyl)cyclohexane (trade name "TETRAD-C", manufactured by MITSUBISHI GAS CHEMICAL COMPANY, INC.) were blended to prepare a solution of an acrylic pressure-sensitive adhesive composition.

(2) Formation of adhesive layer

Next, the acrylic pressure-sensitive adhesive composition solution prepared in the aforementioned (1) was applied to one side of a polyethylene terephthalate film (separator film: MRF38, manufactured by Mitsubishi Polyester Film Inc.) treated with a silicone peeling agent such that the thickness of the dried pressure-sensitive adhesive layer be 10 $\mu$m, and dried at 155°C for 1 minute, thereby forming a pressure-sensitive adhesive layer on the surface of the separator film. This pressure-sensitive adhesive layer corresponds to the "pressure-sensitive adhesive/adhesive layer" arranged on the first main surface side of the first optical sheet in the laminate of the present disclosure.

(3) Formation of laminate

Next, the surface of the pressure-sensitive adhesive layer (pressure-sensitive adhesive/adhesive layer) was attached to an acrylic resin film (thickness: 30 $\mu$m), the separator film (PET film) was peeled off, and the exposed pressure-sensitive adhesive layer was attached to the uneven-shaped film of Reference Example 5, followed by autoclaving at 50°C, 0.5 MPa for 15 minutes, to obtain an optical laminate having a laminated structure of the uneven-shaped film (first optical sheet)/the pressure-sensitive adhesive layer (pressure-sensitive adhesive/adhesive layer)/the acrylic resin film.

[Examples 2 and 3, and Comparative Examples 1 and 2: Production of laminate]

Laminates of Examples 2 and 3, and Comparative Examples 1 and 2 were produced as follows.

In the production of the laminates of Examples 2 and 3, and Comparative Examples 1 and 2, as shown in Table 1 below, the (meth)acrylic polymer (A1) same as in Example 1 was used (Example 3), or one of the (meth)acrylic polymers (A2) to (A4) produced in Reference Examples 2 to 4 was used instead of the (meth)acrylic polymer (A1) (Example 2, and Comparative Examples 1 and 2).

The preparation (production) method and production conditions of the (meth)acrylic polymers (A2) to (A4) are as described in Reference Examples 2 to 4. In the method for preparing the (meth)acrylic polymers (A2) to (A4), the types of monomers and their blending ratios are as described in Reference Examples 2 to 4, and as shown in Table 1 below. The polymer properties (weight-average molecular weight (MW) and polydispersity (Mw/Mn)) of the (meth)acrylic polymers (A2) to (A4) are as shown in Table 1 below.

In Example 2 and Comparative Example 1, except that the (meth)acrylic polymer (A2) or the (meth)acrylic polymer (A3) was used instead of the (meth)acrylic polymer (A1), the acrylic pressure-sensitive adhesive composition solution was prepared in exactly the same manner as described in (1) Preparation of pressure-sensitive adhesive composition in Example 1. The laminates of Example 1 and Reference Example 1 were produced in exactly the same manner as in Example 1, except for the above changes.

In Example 3, an acrylic pressure-sensitive adhesive composition solution was prepared in exactly the same manner as described in (1) Preparation of Pressure Sensitive Adhesive Composition" in Example 1, except that 0.3 parts of an isocyanate crosslinking agent (trade name "CORONATE L", manufactured by Nippon Polyurethane Industry Co., Ltd., adduct of trimethylolpropane and tolylene diisocyanate), 10 pts.mass in terms of solid of a ultraviolet-curable urethane acrylate resin A, and 1.0 pts.mass of 4-(2-hydroxyethoxy)phenyl(2-hydroxy-2-propyl)ketone (trade name "Omnirad 2959", manufactured by IGM Japan GK) as a photopolymerization initiator, which are relative to 100 parts in terms of solid of the (meth)acrylic polymer (A1) solution, were blended. Furthermore, using the acrylic pressure-sensitive adhesive composition solution, a pressure-sensitive adhesive layer was produced in the same manner as in Example 1. Thereafter, the pressure-sensitive adhesive layer was attached to the peeling-treated surface of a polyethylene film having a thickness of 50 $\mu$m, which has been subjected to silicone peeling treatment. Furthermore, the upper side (polyethylene film side) was irradiated with ultraviolet light to cure the curable resin in the pressure-sensitive adhesive layer. Thereafter, the polyethylene film was peeled off. The irradiation with ultraviolet light was performed using an LED lamp (manufactured by Quark Technology Co.,Ltd, peak irradiance: 200 mW/cm$^2$, integrated light amount: 1500 mJ/cm$^2$ (wavelength 345 to 365 nm)). The irradiance of ultraviolet light was measured using UV Power Puck (manufactured by Heraeus Noblelight Fusion UV K.K.). In this way, the pressure-sensitive adhesive layer (pressure-sensitive adhesive/adhesive layer) obtained by curing the curable resin in the pressure-sensitive adhesive layer was used as the "pressure-sensitive adhesive/adhesive layer" in the laminate of the present example (Example 3). Thereafter, the laminate of Example 3 was produced in the same manner as described in the "(3) Formation of laminate" in Example 1.

In Comparative Example 2, except that the (meth)acrylic polymer (A4) was used instead of the (meth)acrylic polymer (A1), the laminate of Comparative Example 2 was produced in exactly the same manner as in Example 3.

[Evaluation of property of laminate in Examples and Comparative Examples]

The properties of the laminates of Examples 1 to 3 and Comparative Examples 1 and 2 produced as described above were measured and evaluated by the methods described above. The results are summarized in Table 1 below. Note that, in Table 1 below, "Polymer composition" shows a composition of each of the (meth)acrylic polymers (A1) to (A4) used for producing the laminate. "BA" represents butyl acrylate. "ACMO" represents N-acryloylmorpholine. "AA" represents acrylic acid. "4HBA" represents 4-hydroxybutyl acrylate.

Table 1

| | (Meth) acrylic polymer | Polymer composition | | | | Mw | Mw/Mn | UV resin | Crosslinking agent | | Gel fraction [%] | Nanoindentation hardness [Mpa] | PMMA adhesive force [N/20mm] | Air cavity-remaining rate [%] |
|---|---|---|---|---|---|---|---|---|---|---|---|---|---|---|
| | | BA | ACMO | AA | 4HBA | | | | Isocyanate | Epoxy | | | | |
| Example 1 | A1 | 83 | 13 | 3 | 1 | 3,000,000 | 2.8 | Absent | 0.3 | 0.1 | 95 | 0.15 | 5.4 Good | 92% Good |
| Example 2 | A2 | 73 | 20 | 6 | 1 | 2,500,000 | 2.4 | Absent | | 0.5 | 87 | 0.69 | 4.2 Good | 92% Good |
| Example 3 | A1 | 83 | 13 | 3 | 1 | 3,000,000 | 2.8 | Present | | 0.5 | 97 | 1.2 | 1.2 Fair | 95% Excellent |
| Comparative Example 1 | A3 | 95 | 1 | 3 | 1 | 1,700,000 | 5.2 | Absent | 0.3 | 0.1 | 92 | 0.09 | 6.2 Excellent | 72% Poor |
| Comparative Example 2 | A4 | 63 | 30 | 6 | 1 | 2,300,000 | 2.8 | Present | | 0.5 | 99 | 2.21 | Failed in attachment | 97% Excellent |

As shown in Table 1, the laminates of Examples 1 to 3, where the nanoindentation hardness of the pressure-sensitive adhesive/adhesive layer was within the range of the present disclosure (0.1 MPa or more and 2.0 MPa or less) all had high PMMA adhesive force of 1.0 mN/20mm or more, and high air cavity-remaining rate of 90% or more. The high PMMA adhesive force shows excellence in adhesive force or pressure-sensitive adhesive force to other member(s). The high air cavity-remaining rate shows that the intrusion of the pressure-sensitive adhesive/adhesive into the recessed portions of the uneven structure of the first optical sheet is suppressed. In other words, the laminates of Examples 1 to 3 all achieved suppression of the intrusion of the pressure-sensitive adhesive/adhesive into the recessed portions of the uneven structure, and had good adhesive force or pressure-sensitive adhesive force to the other member(s). In contrast, the laminate of Comparative Example 1, which includes the pressure-sensitive adhesive/adhesive layer having excessively small nanoindentation harness (too soft), achieved high PMMA adhesive force, but had lower air cavity-remaining rate than that in Examples. On the other hand, the laminate of Comparative Example 2, which includes the pressure-sensitive adhesive/adhesive layer having excessively large nanoindentation harness (too hard), achieved high air cavity-remaining rate. However, due to the low pressure-sensitive adhesive force (adhesive force) of the pressure-sensitive adhesive/adhesive layer, the laminate of Comparative Example 2 was not be able to attached to PMMA, resulting in failure of the measurement of the PMMA adhesive force.

SUPPLEMENTARY NOTE

The whole or part of the example embodiments disclosed above can be described as, but not limited to, the following supplementary notes.

(Supplementary Note 1)

A laminate, including:

a first optical sheet, and
a pressure-sensitive adhesive/adhesive layer, wherein
the first optical sheet includes:

a first main surface with an uneven structure, and
a second main surface opposite to the first main surface,
the pressure-sensitive adhesive/adhesive layer is arranged on the first surface side of the first optical sheet,
the uneven structure of the first main surface includes:

a plurality of recessed portions, and
a flat portion between each two adjacent recessed portions among the plurality of recessed portions,
the flat portion of the first main surface is in contact with the pressure-sensitive adhesive/adhesive layer,
the pressure-sensitive adhesive/adhesive layer includes a (meth)acrylic polymer, and a nanoindentation hardness, measured by pressing an indenter of a nanoindenter into the pressure-sensitive adhesive/adhesive layer by 2,000 nm, is 0.1 MPa or more and 2.0 MPa or less.

(Supplementary Note 2)

The laminate according to Supplementary Note 1, wherein
in the first optical sheet, each of the recessed portions of the first main surface forms a space between the recessed portion and a surface of the pressure-sensitive adhesive/adhesive layer.

(Supplementary Note 3)

The laminate according to Supplementary Note 1 or 2, wherein
the (meth)acrylic polymer includes a nitrogen-containing monomer of 1 to 30 wt% as a monomer unit.

(Supplementary Note 4)

The laminate according to Supplementary Note 3 or 4, wherein
polydispersity (weight-average molecular weight (Mw)/number-average molecular weight (Mn)) of the (meth)acrylic polymer is 3.0 or less.

(Supplementary Note 5)

The laminate according to Supplementary Note 3 or 4, wherein
the nitrogen-containing monomer is a heterocycle-containing acrylic monomer.

(Supplementary Note 6)

The laminate according to any one of Supplementary Notes 1 to 5, wherein
the pressure-sensitive adhesive/adhesive layer is formed of a pressure-sensitive adhesive/adhesive including the (meth)
acrylic polymer and a crosslinking agent, and gel fraction of the pressure-sensitive adhesive/adhesive is more than 85%.

(Supplementary Note 7)

The laminate according to any one of Supplementary Notes 1 to 6, wherein
the (meth)acrylic polymer substantially exclude the (meth)acrylic polymer having a polystyrene-equivalent molecular
weight of 100,000 or less.

(Supplementary Note 8)

The laminate according to any one of Supplementary Notes 1 to 7, wherein
a weight-average molecular weight (Mw) of the (meth)acrylic polymer is 1,500,000 to 4,000,000.

(Supplementary Note 9)

An optical member comprising the laminate according to any one of Supplementary Notes 1 to 8.

(Supplementary Note 10)

An optical apparatus comprising the optical member according to Supplementary Note 9.

(Supplementary Note 11)

A method for producing the laminate according to any one of Supplementary Notes 1 to 8, including
attaching the pressure-sensitive adhesive/adhesive layer to the first main surface of the first optical sheet.

Industrial Applicability

As described above,
The application of the present invention is not particularly limited. For example, the optical apparatus of the present
invention is not particularly limited, and may be an image display device, an illumination device, or the like. Examples of the
image display device include a liquid crystal display, an organic EL display, and a micro LED display. The illumination
device may be, for example, an organic EL illumination, or the like. Furthermore, the application of the optical laminate of
the present invention is not limited to the optical member and the optical apparatus of the present invention, and can be
used in a wide range of applications.
This application claims priority from Japanese Patent Application No. 2023-046050 filed on March 22, 2023. The
entire subject matter of the Japanese Patent Application is incorporated herein by reference.

Reference Signs List

| 10a: | first optical sheet |
| 12s, 18s: | main surface (surface) |
| 20a: | pressure-sensitive adhesive/adhesive layer |
| 60: | light source |
| 80: | light guiding layer |
| 100A, 101A, 102A, 102B: | optical laminate |
| 200A, 200B: | illumination apparatus |

**Claims**

1. A laminate, comprising:

a first optical sheet, and
a pressure-sensitive adhesive/adhesive layer, wherein
the first optical sheet includes:

a first main surface with an uneven structure, and
a second main surface opposite to the first main surface,
the pressure-sensitive adhesive/adhesive layer is arranged on the first surface side of the first optical sheet,
the uneven structure of the first main surface includes:

a plurality of recessed portions, and
a flat portion between each two adjacent recessed portions among the plurality of recessed portions,
the flat portion of the first main surface is in contact with the pressure-sensitive adhesive/adhesive layer,
the pressure-sensitive adhesive/adhesive layer includes a (meth)acrylic polymer, and
a nanoindentation hardness, measured by pressing an indenter of a nanoindenter into the pressure-sensitive adhesive/adhesive layer by 2,000 nm, is 0.1 MPa or more and 2.0 MPa or less.

2. The laminate according to claim 1, wherein
in the first optical sheet, each of the recessed portions of the first main surface forms a space between the recessed portion and a surface of the pressure-sensitive adhesive/adhesive layer.

3. The laminate according to claim 1, wherein
the (meth)acrylic polymer includes a nitrogen-containing monomer of 1 to 30 wt% as a monomer unit.

4. The laminate according to claim 3, wherein
polydispersity (weight-average molecular weight (Mw)/number-average molecular weight (Mn)) of the (meth)acrylic polymer is 3.0 or less.

5. The laminate according to claim 3, wherein
the nitrogen-containing monomer is a heterocycle-containing acrylic monomer.

6. The laminate according to claim 1, wherein
the pressure-sensitive adhesive/adhesive layer is formed of a pressure-sensitive adhesive/adhesive including the (meth)acrylic polymer and a crosslinking agent, and gel fraction of the pressure-sensitive adhesive/adhesive is more than 85%.

7. The laminate according to claim 1, wherein
the (meth)acrylic polymer substantially exclude the (meth)acrylic polymer having a polystyrene-equivalent molecular weight of 100,000 or less.

8. The laminate according to claim 1, wherein
a weight-average molecular weight (Mw) of the (meth)acrylic polymer is 1,500,000 to 4,000,000.

9. An optical member comprising the laminate according to any one of claims 1 to 8.

10. An optical apparatus comprising the optical member according to claim 9.

11. A method for producing the laminate according to any one of claims 1 to 8, comprising
attaching the pressure-sensitive adhesive/adhesive layer to the first main surface of the first optical sheet.

FIG. 1A

FIG. 1B

FIG. 2

12s(10s)

10a

14

17s

16s

18s

Y

X

Z

FIG. 3

FIG. 4A

FIG. 4B

FIG. 5A

FIG. 5B

FIG. 6A

FIG. 6B

FIG. 6C

# EP 4 681 919 A1

## INTERNATIONAL SEARCH REPORT

| | International application No. |
|---|---|
| | **PCT/JP2024/011016** |

### A. CLASSIFICATION OF SUBJECT MATTER

*B32B 27/30*(2006.01)i; *B32B 3/26*(2006.01)i; *C09J 7/38*(2018.01)i; *C09J 11/06*(2006.01)i; *C09J 133/00*(2006.01)i; *G02B 5/30*(2006.01)n; *H10K 50/856*(2023.01)n; *H10K 59/95*(2023.01)n
FI:   B32B27/30 A; B32B3/26 A; C09J7/38; C09J11/06; C09J133/00; G02B5/30; H10K50/856; H10K59/95

According to International Patent Classification (IPC) or to both national classification and IPC

### B. FIELDS SEARCHED

Minimum documentation searched (classification system followed by classification symbols)

B32B1/00-43/00; C09J7/00-7/50; C09J133/00; F21S2/00; F21V5/00; F21V7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2022/176659 A1 (NITTO DENKO CORPORATION) 25 August 2022 (2022-08-25)<br>claims, example 1, comparative example 1, tables 1, 2 | 1-11 |
| A | WO 2021/167090 A1 (NITTO DENKO CORPORATION) 26 August 2021 (2021-08-26)<br>claims, paragraphs [0018]-[0023], [0068], [0069], example 2, comparative examples 1, 2 | 1-11 |
| A | WO 2021/167091 A1 (NITTO DENKO CORPORATION) 26 August 2021 (2021-08-26)<br>claims, paragraphs [0066], [0067], example 8, comparative examples 4, 5 | 1-11 |
| A | JP 2011-26361 A (LINTEC CORPORATION) 10 February 2011 (2011-02-10)<br>claims, paragraphs [0002]-[0004], [0034], examples 1, 2 | 1-11 |
| A | JP 2019-178283 A (TOMOEGAWA PAPER CO., LTD.) 17 October 2019 (2019-10-17)<br>claims, paragraphs [0007], [0034]-[0038], [0046], [0047], examples 1-3, tables 1, 2 | 1-11 |

☐ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **27 May 2024** | **04 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

### INTERNATIONAL SEARCH REPORT
#### Information on patent family members

International application No.

**PCT/JP2024/011016**

| Patent document cited in search report | | | Publication date (day/month/year) | Patent family member(s) | | | Publication date (day/month/year) |
|---|---|---|---|---|---|---|---|
| WO | 2022/176659 | A1 | 25 August 2022 | US 2024/0061157 A1<br>claims, example 1,<br>comparative example 1, tables<br>1, 2<br>EP 4296329 A1<br>CN 116670244 A<br>KR 10-2023-0146000 A | | | |
| WO | 2021/167090 | A1 | 26 August 2021 | US 2023/0102613 A1<br>claims, paragraphs [0095]-<br>[0100], [0154], [0155],<br>example 2, comparative<br>examples 1, 2<br>EP 4108455 A1<br>CN 115135738 A<br>KR 10-2022-0143038 A<br>TW 202140717 A | | | |
| WO | 2021/167091 | A1 | 26 August 2021 | US 2023/0110868 A1<br>claims, paragraphs [0127],<br>[0128], example 8,<br>comparative examples 4, 5<br>EP 4108731 A1<br>CN 115151620 A<br>KR 10-2022-0143039 A<br>TW 202136460 A | | | |
| JP | 2011-26361 | A | 10 February 2011 | (Family: none) | | | |
| JP | 2019-178283 | A | 17 October 2019 | (Family: none) | | | |

Form PCT/ISA/210 (patent family annex) (July 2022)

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022176659 A
- WO 2011124765 A
- WO 2019087118 A
- JP 2013524288 T
- JP 2023046050 A